(19) Europäisches Patentamt
European Patent Office
Office européen des brevets

(11) **EP 4 542 864 A1**

(12) **EUROPEAN PATENT APPLICATION**

(43) Date of publication:
**23.04.2025 Bulletin 2025/17**

(21) Application number: **24188844.5**

(22) Date of filing: **16.07.2024**

(51) International Patent Classification (IPC):
**H03M 13/11** (2006.01)   **H03M 13/00** (2006.01)
**H04L 1/00** (2006.01)   **H04L 5/00** (2006.01)

(52) Cooperative Patent Classification (CPC):
**H04L 5/0007; H03M 13/1102; H03M 13/618;
H03M 13/635; H03M 13/6516; H04L 1/0041;
H04L 1/0057; H04L 1/0067**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **20.10.2023 US 202318382459**

(71) Applicant: **INTEL Corporation
Santa Clara, CA 95054 (US)**

(72) Inventors:
• **FANG, Juan
Portland OR, 97225 (US)**
• **LI, Qinghua
San Ramon CA, 94583 (US)**
• **STACEY, Robert
Portland OR, 97210 (US)**

(74) Representative: **Viering, Jentschura & Partner
mbB
Patent- und Rechtsanwälte
Am Brauhaus 8
01099 Dresden (DE)**

(54) **LDPC ENCODED PROCESS WITH LONGER LDPC CODE WORD LENGTH IN UHR**

(57)   An apparatus and method of encoding Low-Density Parity Check (LDPC) Physical Layer Convergence Protocol (PLCP) packet protocol data units (PPDU) is disclosed. For LDPC codeword of lengths 3888 and/or 7776, the number and length of codewords to use may depend on the number of available bits. In this case, if the number of available bits is larger than 1944 and less than 2596, two codewords of length 1944 or a single codeword of length 3888 to encode the PPDU is used to encode the PPDU. For larger numbers of available bits, one or more codewords of length 3888 or 7776 is used to encode the PPDU. Shortening and/or puncturing, when used, is also based on the number of available bits.

FIG. 8

**Description**

TECHNICAL FIELD

Embodiments pertain to wireless networks and wireless communications. Some embodiments relate to wireless local area networks (WLANs) and Wi-Fi networks including networks operating under the IEEE 802.11 family of standards. Some embodiments relate to encoding mechanisms to higher bandwidth operation using increased Low-Density Parity Check (LDPC) codeword length.

BACKGROUND

LDPC codes are linear error correcting codes used to provide error correction in a noisy channel of a communication system, allowing for faster and more robust communication. LDPC codes are functionally defined by a sparse parity-check matrix that may be randomly generated. Updates to encoding mechanisms are desirable based on the introduction of new codeword lengths.

BRIEF DESCRIPTION OF THE DRAWINGS

The present disclosure is illustrated by way of example and not limitation in the figures of the accompanying drawings, in which like references indicate similar elements and in which:

FIG. 1 is a block diagram of a radio architecture in accordance with some embodiments;

FIG. 2 illustrates front-end module (FEM) circuitry in accordance with some embodiments;

FIG. 3 illustrates radio integrated circuit (IC) circuitry in accordance with some embodiments;

FIG. 4 illustrates a functional block diagram of baseband processing circuitry in accordance with some embodiments;

FIG. 5 illustrates a Wireless Local Area Network (WLAN) in accordance with some embodiments;

FIG. 6 is a network diagram illustrating an example network environment, in accordance with some embodiments;

FIG. 7 is a process of LDPC Physical Layer Convergence Protocol (*PLCP*) packet protocol data unit (PPDU) encoding, in accordance with some embodiments;

FIG. 8 is a flow diagram of an example method for enhancing LDPC PPDU encoding, in accordance with some embodiments;

FIG. 9 illustrates a block diagram of an example machine upon which any one or more of the techniques (e.g., methodologies) discussed herein may perform; and

FIG. 10 illustrates a block diagram of an example wireless device upon which any one or more of the techniques (e.g., methodologies or operations) discussed herein may perform.

DESCRIPTION

The following description and the drawings sufficiently illustrate specific embodiments to enable those skilled in the art to practice them. Other embodiments may incorporate structural, logical, electrical, process, and other changes. Portions and features of some embodiments may be included in or substituted for, those of other embodiments. Embodiments outlined in the claims encompass all available equivalents of those claims.

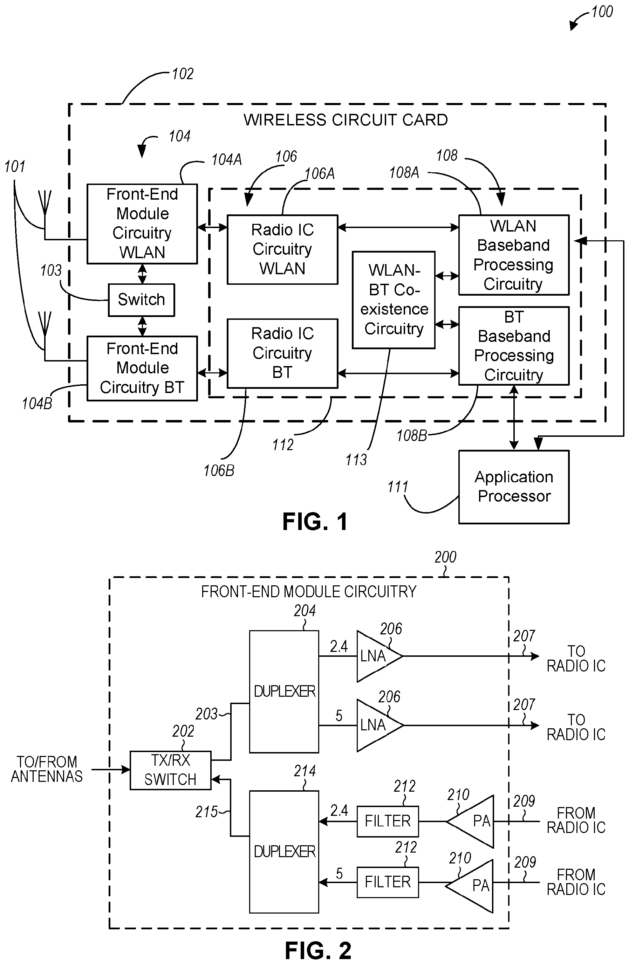

FIG. 1 is a block diagram of a radio architecture 100 in accordance with some embodiments. Radio architecture 100 may include radio front-end module (FEM) circuitry 104, radio IC circuitry 106, and baseband processing circuitry 108. Radio architecture 100 as shown includes both Wireless Local Area Network (WLAN) functionality and Bluetooth (BT) functionality although embodiments are not so limited. In this disclosure, "WLAN" and "Wi-Fi" are used interchangeably.

FEM circuitry 104 may include a WLAN (or Wi-Fi) FEM circuitry 104A and a Bluetooth (BT) FEM circuitry 104B. The WLAN FEM circuitry 104A may include a receive signal path comprising circuitry configured to operate on WLAN RF signals received from one or more antennas 101, to amplify the received signals, and to provide the amplified versions of the received signals to the WLAN radio IC circuitry 106A for further processing. The BT FEM circuitry 104B may include a receive signal path which may include circuitry configured to operate on BT RF signals received from one or more antennas 101, to amplify the received signals, and to provide the amplified versions of the received signals to the BT radio IC circuitry 106B for further processing. WLAN FEM circuitry 104A may also include a transmit signal path which may include circuitry configured to amplify WLAN signals provided by the WLAN radio IC circuitry 106A for wireless transmission by the one or more antennas 101. In addition, BT FEM circuitry 104B may also include a transmit signal path which may include circuitry configured to amplify BT signals provided by the radio IC circuitry 106B for wireless transmission by one or more antennas. In the embodiment of FIG. 1, although WLAN FEM circuitry 104A and BT FEM circuitry 104B are shown as being distinct from one another, embodiments are not so limited and include within their scope the use of a FEM (not shown) that includes a transmit path and/or a receive path for both WLAN and BT signals or the use of one or more FEM circuitries where at least some of the FEM circuitries share transmit and/or receive signal paths for both WLAN and BT signals.

Radio IC circuitry 106 as shown may include WLAN radio IC circuitry 106A and BT radio IC circuitry 106B. The WLAN radio IC circuitry 106A may include a receive signal path which may include circuitry to down-convert WLAN RF signals received from the WLAN FEM circuitry 104A and provide baseband signals to WLAN baseband processing circuitry 108A. BT radio IC circuitry 106B may, in turn, include a receive signal path which may include circuitry to down-convert BT RF signals received from the BT FEM circuitry 104B and provide baseband signals to BT baseband processing circuitry 108B. The WLAN radio IC circuitry 106A may also include a transmit signal path which may include circuitry to up-convert WLAN baseband signals provided by the WLAN baseband processing circuitry 108A and provide WLAN RF output signals to the WLAN FEM circuitry 104A for subsequent wireless transmission by one or more antennas 101. BT radio IC circuitry 106B may also include a transmit signal path which may include circuitry to up-convert BT baseband signals provided by the BT baseband processing circuitry 108B and provide BT RF output signals to the BT FEM circuitry 104B for subsequent wireless transmission by the one or more antennas 101. In the embodiment of FIG. 1, although radio IC circuitries 106A and 106B are shown as being distinct from one another, embodiments are not so limited and include within their scope the use of a radio IC circuitry (not shown) that includes a transmit signal path and/or a receive signal path for both WLAN and BT signals, or the use of one or more radio IC circuitries where at least some of the radio IC circuitries share transmit and/or receive signal paths for both WLAN and BT signals.

Baseband processing circuitry 108 may include a WLAN baseband processing circuitry 108A and a BT baseband processing circuitry 108B. The WLAN baseband processing circuitry 108A may include a memory, such as, for example, a set of RAM arrays in a Fast Fourier Transform or Inverse Fast Fourier Transform block (not shown) of the WLAN baseband processing circuitry 108A. Each of the WLAN baseband processing circuitry 108A and the BT baseband processing circuitry 108B may further include one or more processors and control logic to process the signals received from the corresponding WLAN or BT receive signal path of the radio IC circuitry 106, and to also generate corresponding WLAN or BT baseband signals for the transmit signal path of the radio IC circuitry 106. Each of the baseband processing circuitries 108A and 108B may further include a physical layer (PHY) and medium access control layer (MAC) circuitry, and may further interface with the application processor 111 for generation and processing of the baseband signals and for controlling operations of the radio IC circuitry 106.

Referring still to FIG. 1, according to the shown embodiment, WLAN-BT coexistence circuitry 113 may include logic providing an interface between the WLAN baseband processing circuitry 108A and the BT baseband processing circuitry 108B to enable use cases requiring WLAN and BT coexistence. In addition, a switch 103 may be provided between the WLAN FEM circuitry 104A and the BT FEM circuitry 104B to allow switching between the WLAN and BT radios according to application needs. In addition, although the one or more antennas 101 are depicted as being respectively connected to the WLAN FEM circuitry 104A and the BT FEM circuitry 104B, embodiments include within their scope the sharing of one or more antennas as between the WLAN and BT FEMs, or the provision of more than one antenna connected to each of the WLAN FEM circuitry 104A or the BT FEM circuitry 104B.

In some embodiments, the FEM circuitry 104, the radio IC circuitry 106, and baseband processing circuitry 108 may be provided on a single radio card, such as wireless radio card 102. In some other embodiments, one or more antennas 101, the FEM circuitry 104 and the radio IC circuitry 106 may be provided on a single radio card. In some other embodiments, the radio IC circuitry 106 and the baseband processing circuitry 108 may be provided on a single chip or IC, such as IC 112.

In some embodiments, the wireless radio card 102 may include a WLAN radio card and may be configured for Wi-Fi communications, although the scope of the embodiments is not limited in this respect. In some of these embodiments, the radio architecture 100 may be configured to receive and transmit orthogonal frequency division multiplexed (OFDM) or orthogonal frequency division multiple access (OFDMA) communication signals over a multicarrier communication channel. The OFDM or OFDMA signals may comprise a plurality of orthogonal subcarriers.

In some of these multicarrier embodiments, radio architecture 100 may be a part of a Wi-Fi communication station (STA) such as a wireless access point (AP), a base station, or a mobile device including a Wi-Fi device. In some of these embodiments, radio architecture 100 may be configured to transmit and receive signals in accordance with specific communication standards and/or protocols, such as any of the Institute of Electrical and Electronics Engineers (IEEE) standards including, IEEE 802.11n-2009, IEEE 802.11-2012, IEEE 802.11-2016, IEEE 802.11ac, and/or IEEE 802.11ax, and/or IEEE 802.11be standards and/or proposed specifications for WLANs, although the scope of embodiments is not limited in this respect. Radio architecture 100 may also be suitable to transmit and/or receive communications in accordance with other techniques and standards.

In some embodiments, the radio architecture 100 may be configured for high-efficiency (HE) Wi-Fi (HEW), extremely high throughput (EHT), and ultra high reliability (UHR) communications in accordance with the IEEE 802.11ax, 802.11be, and 802.11bn standards. In these embodiments, the radio architecture 100 may be configured to communicate in accordance with an OFDMA technique, although the scope of the embodiments is not limited in this respect.

In some other embodiments, the radio architecture 100 may be configured to transmit and receive signals transmitted using one or more other modulation techniques such as spread spectrum modulation (e.g., direct sequence code division multiple access (DS-CDMA) and/or frequency hopping code division multiple access (FH-CDMA)), time-division multiplexing (TDM) modulation, and/or frequency-division multiplexing (FDM) modulation, although the scope of the embodiments is not limited in this respect.

In some embodiments, as further shown in FIG. 1, the BT baseband processing circuitry 108B may be compliant with a Bluetooth (BT) connectivity standard such as Bluetooth, Bluetooth 4.0 or Bluetooth 5.0, or any other iteration of the Bluetooth Standard. In embodiments that include BT functionality as shown for example in Fig. 1, the radio architecture 100 may be configured to establish a BT synchronous connection-oriented (SCO) link and/or a BT low energy (BT LE) link. In some of the embodiments that include functionality, the radio architecture 100 may be configured to establish an extended SCO (eSCO) link for BT communications, although the scope of the embodiments is not limited in this respect. In some of these embodiments that include a BT functionality, the radio architecture may be configured to engage in a BT Asynchronous Connection-Less (ACL) communications, although the scope of the embodiments is not limited in this respect. In some embodiments, as shown in FIG. 1, the functions of a BT radio card and WLAN radio card may be combined on a single wireless radio card, such as the wireless radio card 102, although embodiments are not so limited, and include within their scope discrete WLAN and BT radio cards.

In some embodiments, the radio architecture 100 may include other radio cards, such as a cellular radio card configured for cellular (e.g., 3GPP such as LTE, LTE-Advanced, or 5G communications).

In some IEEE 802.11 embodiments, the radio architecture 100 may be configured for communication over various channel bandwidths including bandwidths having center frequencies of about 900 MHz, 2.4 GHz, 5 GHz, and bandwidths of about 1 MHz, 2 MHz, 2.5 MHz, 4 MHz, 5MHz, 8 MHz, 10 MHz, 16 MHz, 20 MHz, 40 MHz, 80 MHz (with contiguous bandwidths) or 80+80 MHz (160 MHz) (with non-contiguous bandwidths). In some embodiments, a 320 MHz channel bandwidth may be used. However, the scope of the embodiments is not limited concerning the above center frequencies.

FIG. 2 illustrates FEM circuitry 200 in accordance with some embodiments. The FEM circuitry 200 is one example of circuitry that may be suitable for use as the WLAN FEM circuitry 104A and/or the BT FEM circuitry 104B (of FIG. 1), although other circuitry configurations may also be suitable.

In some embodiments, the FEM circuitry 200 may include a TX/RX switch 202 to switch between transmit mode and receive mode operation. The FEM circuitry 200 may include a receive signal path and a transmit signal path. The receive signal path of the FEM circuitry 200 may include a low-noise amplifier (LNA) 206 to amplify received RF signals 203 and provide the amplified received RF signals 207 as an output (e.g., to the radio IC circuitry 106 (FIG. 1)). The transmit signal path of the FEM circuitry 200 may include a power amplifier (PA) to amplify input RF signals 209 (e.g., provided by the radio IC circuitry 106), and one or more filters 212, such as band-pass filters (BPFs), low-pass filters (LPFs) or other types of filters, to generate RF signals 215 for subsequent transmission (e.g., by the one or more antennas 101 (FIG. 1)). In some multi-mode embodiments for Wi-Fi communication, the FEM circuitry 200 may be configured to operate in any of the 2.4 GHz frequency spectrum, the 5 GHz frequency spectrum, and 6 GHz frequency spectrum. In these embodiments, the receive signal path of the FEM circuitry 200 may include a receive signal path duplexer 204 to separate the signals from each spectrum as well as provide a separate LNA 206 for each spectrum as shown. In these embodiments, the transmit signal path of the FEM circuitry 200 may also include a power amplifier 210 and one or more filters 212, such as a BPF, an LPF, or another type of filter for each frequency spectrum and a transmit signal path duplexer 214 to provide the signals of one of the different spectrums onto a single transmit path for subsequent transmission by the one or more antennas 101 (FIG. 1). In some embodiments, BT communications may utilize the 2.4 GHz signal paths and may utilize the same FEM circuitry 200 as the one used for WLAN communications.

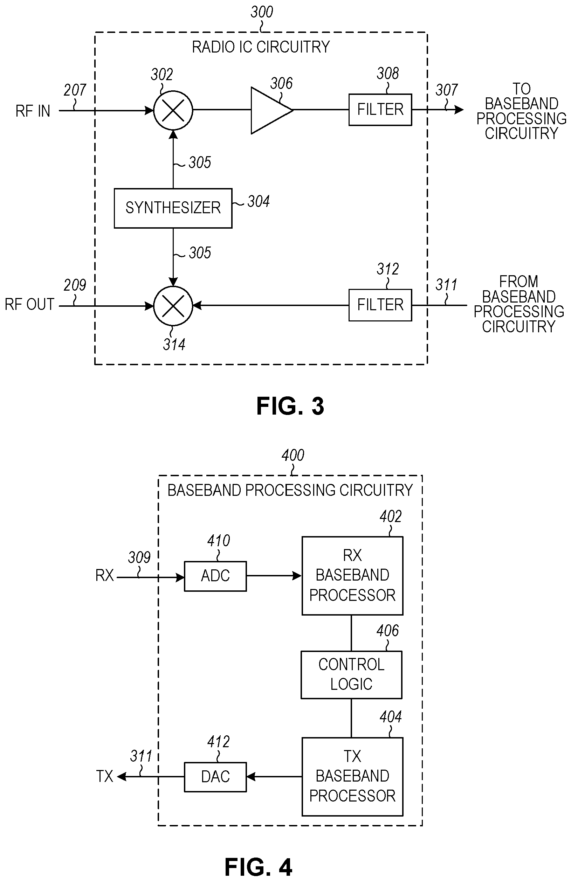

FIG. 3 illustrates radio integrated circuit (IC) circuitry 300 in accordance with some embodiments. The radio IC circuitry 300 is one example of circuitry that may be suitable for use as the WLAN radio IC circuitry 106A or the BT radio IC circuitry 106B (of FIG. 1), although other circuitry configurations may also be suitable.

In some embodiments, the radio IC circuitry 300 may include a receive signal path and a transmit signal path. The receive signal path of the radio IC circuitry 300 may include mixer circuitry 302, such as, for example, down-conversion mixer circuitry, amplifier circuitry 306, and filter circuitry 308. The transmit signal path of the radio IC circuitry 300 may include filter circuitry 312 and mixer circuitry 314, such as up-conversion mixer circuitry. Radio IC circuitry 300 may also include synthesizer circuitry 304 for synthesizing a frequency 305 for use by the mixer circuitry 302 and the mixer circuitry 314. The mixer circuitry 302 and/or 314 may each, according to some embodiments, be configured to provide direct conversion functionality. The latter type of circuitry presents a much simpler architecture as compared with standard super-heterodyne mixer circuitries, and any flicker noise brought about by the same may be alleviated for example through the use of OFDM modulation. FIG. 3 illustrates only a simplified version of a radio IC circuitry and may include, although not shown, embodiments where each of the depicted circuitries may include more than one component. For instance, mixer circuitry 302 and/or 314 may each include one or more mixers, and filter circuitry 308 and/or 312 may each include one or more filters, such as one or more BPFs and/or LPFs according to application needs. For example, when mixer circuitries are of the direct-conversion type, they may each include two or more mixers.

In some embodiments, mixer circuitry 302 may be configured to down-convert RF signals 207 received from the FEM circuitry 104 (FIG. 1) based on the frequency 305 provided by synthesizer circuitry 304. The amplifier circuitry 306 may be configured to amplify the down-converted signals and the filter circuitry 308 may include an LPF configured to remove unwanted signals from the down-converted signals to generate output baseband signals 307. Output baseband signals 307 may be provided to the baseband processing circuitry 108 (FIG. 1) for further processing. In some embodiments, the output baseband signals 307 may be zero-frequency baseband signals, although this is not a requirement. In some embodiments, mixer circuitry 302 may comprise passive mixers, although the scope of the embodiments is not limited in this respect.

In some embodiments, the mixer circuitry 314 may be configured to up-convert baseband signals 311 based on the frequency 305 provided by the synthesizer circuitry 304 to generate RF signals 209 for the FEM circuitry 104. The baseband signals 311 may be provided by the baseband processing circuitry 108 and may be filtered by filter circuitry 312. The filter circuitry 312 may include an LPF or a BPF, although the scope of the embodiments is not limited in this respect.

In some embodiments, the mixer circuitry 302 and the mixer circuitry 314 may each include two or more mixers and may be arranged for quadrature down-conversion and/or up-conversion respectively with the help of synthesizer circuitry 304. In some embodiments, the mixer circuitry 302 and the mixer circuitry 314 may each include two or more mixers each configured for image rejection (e.g., Hartley image rejection). In some embodiments, the mixer circuitry 302 and the mixer circuitry 314 may be arranged for direct down-conversion and/or direct up-conversion, respectively. In some embodiments, the mixer circuitry 302 and the mixer circuitry 314 may be configured for super-heterodyne operation, although this is not a requirement.

Mixer circuitry 302 may comprise, according to one embodiment: quadrature passive mixers (e.g., for the in-phase (I) and quadrature-phase (Q) paths). In such an embodiment, RF signals 207 from FIG. 3 may be down-converted to provide I and Q baseband output signals to be sent to the baseband processor.

Quadrature passive mixers may be driven by zero and ninety-degree time-varying LO switching signals provided by a quadrature circuitry which may be configured to receive a LO frequency (LO) from a local oscillator or a synthesizer, such as frequency 305 of synthesizer circuitry 304 (FIG. 3). In some embodiments, the LO frequency may be the carrier frequency, while in other embodiments, the LO frequency may be a fraction of the carrier frequency (e.g., one-half the carrier frequency, one-third the carrier frequency). In some embodiments, the zero and ninety-degree time-varying switching signals may be generated by the synthesizer, although the scope of the embodiments is not limited in this respect.

In some embodiments, the LO signals may differ in the duty cycle (the percentage of one period in which the LO signal is high) and/or offset (the difference between the start points of the period). In some embodiments, the LO signals may have a 25% duty cycle and a 50% offset. In some embodiments, each branch of the mixer circuitry (e.g., the in-phase (I) and quadrature-phase (Q) path) may operate at a 25% duty cycle, which may result in a significant reduction in power consumption.

The RF signals 207 (FIG. 2) may comprise a balanced signal, although the scope of the embodiments is not limited in this respect. The I and Q baseband output signals may be provided to the low-noise amplifier, such as amplifier circuitry 306 (FIG. 3) or filter circuitry 308 (FIG. 3).

In some embodiments, the output baseband signals 307 and the baseband signals 311 may be analog, although the scope of the embodiments is not limited in this respect. In some alternate embodiments, the output baseband signals 307 and the baseband signals 311 may be digital. In these alternate embodiments, the radio IC circuitry may include an analog-to-digital converter (ADC) and digital-to-analog converter (DAC) circuitry.

In some dual-mode embodiments, a separate radio IC circuitry may be provided for processing signals for each spectrum, or for other spectrums not mentioned here, although the scope of the embodiments is not limited in this respect.

In some embodiments, the synthesizer circuitry 304 may be a fractional-N synthesizer or a fractional N/N+1 synthesizer, although the scope of the embodiments is not limited in this respect as other types of frequency synthesizers may be suitable. For example, synthesizer circuitry 304 may be a delta-sigma synthesizer, a frequency multiplier, or a synthesizer comprising a phase-locked loop with a frequency divider. According to some embodiments, the synthesizer circuitry 304 may include digital synthesizer circuitry. An advantage of using a digital synthesizer circuitry is that, although it may still include some analog components, its footprint may be scaled down much more than the footprint of an analog synthesizer circuitry. In some embodiments, frequency input into synthesizer circuitry 304 may be provided by a voltage-controlled oscillator (VCO), although that is not a requirement. A divider control input may further be provided by either the baseband processing circuitry 108 (FIG. 1) or the application processor 111 (FIG. 1) depending on the desired output frequency. In some embodiments, a divider control input (e.g., N) may be determined from a look-up table (e.g., within a Wi-Fi card) based on a channel number and a channel center frequency as determined or indicated by the application processor 111.

In some embodiments, synthesizer circuitry 304 may be configured to generate a carrier frequency as frequency 305, while in other embodiments, frequency 305 may be a fraction of the carrier frequency (e.g., one-half the carrier frequency, one-third the carrier frequency). In some embodiments, frequency 305 may be a LO frequency (LO).

FIG. 4 illustrates a functional block diagram of baseband processing circuitry 400 in accordance with some embodiments. The baseband processing circuitry 400 is one example of circuitry that may be suitable for use as the baseband processing circuitry 108 (FIG. 1), although other circuitry configurations may also be suitable. The baseband processing circuitry 400 may include a receive baseband processor 402 for processing receive baseband signals 309 provided by the radio IC circuitry 106 (FIG. 1) and a transmit baseband processor 404 for generating baseband signals 311 for the radio IC circuitry 106. The baseband processing circuitry 400 may also include control logic 406 for coordinating the operations of the baseband processing circuitry 400.

In some embodiments (e.g., when analog baseband signals are exchanged between the baseband processing circuitry 400 and the radio IC circuitry 106), the baseband processing circuitry 400 may include ADC 410 to convert analog baseband signals received from the radio IC circuitry 106 to digital baseband signals for processing by the receive baseband processor 402. In these embodiments, the baseband processing circuitry 400 may also include DAC 412 to convert digital baseband signals from the transmit baseband processor 404 to analog baseband signals.

In some embodiments that communicate OFDM signals or OFDMA signals, such as through the WLAN baseband processing circuitry 108A, the transmit baseband processor 404 may be configured to generate OFDM or OFDMA signals as appropriate for transmission by performing an inverse fast Fourier transform (IFFT). The receive baseband processor 402 may be configured to process received OFDM signals or OFDMA signals by performing an FFT. In some embodiments, the receive baseband processor 402 may be configured to detect the presence of an OFDM signal or OFDMA signal by performing an autocorrelation, to detect a preamble, such as a short preamble, and by performing a cross-correlation, to detect a long preamble. The preambles may be part of a predetermined frame structure for Wi-Fi communication.

Referring to FIG. 1, in some embodiments, the one or more antennas 101 (FIG. 1) may each comprise one or more directional or omnidirectional antennas, including, for example, dipole antennas, monopole antennas, patch antennas, loop antennas, microstrip antennas, or other types of antennas suitable for transmission of RF signals. In some multiple-input multiple-output (MIMO) embodiments, the antennas may be effectively separated to take advantage of spatial diversity and the different channel characteristics that may result. The one or more antennas 101 may each include a set of phased-array antennas, although embodiments are not so limited.

Although the radio architecture 100 is illustrated as having several separate functional elements, one or more of the functional elements may be combined and may be implemented by combinations of software-configured elements, such as processing elements including digital signal processors (DSPs), and/or other hardware elements. For example, some elements may comprise one or more microprocessors, DSPs, field-programmable gate arrays (FPGAs), application-specific integrated circuits (ASICs), radio-frequency integrated circuits (RFICs), and combinations of various hardware and logic circuitry for performing at least the functions described herein. In some embodiments, the functional elements may refer to one or more processes operating on one or more processing elements.

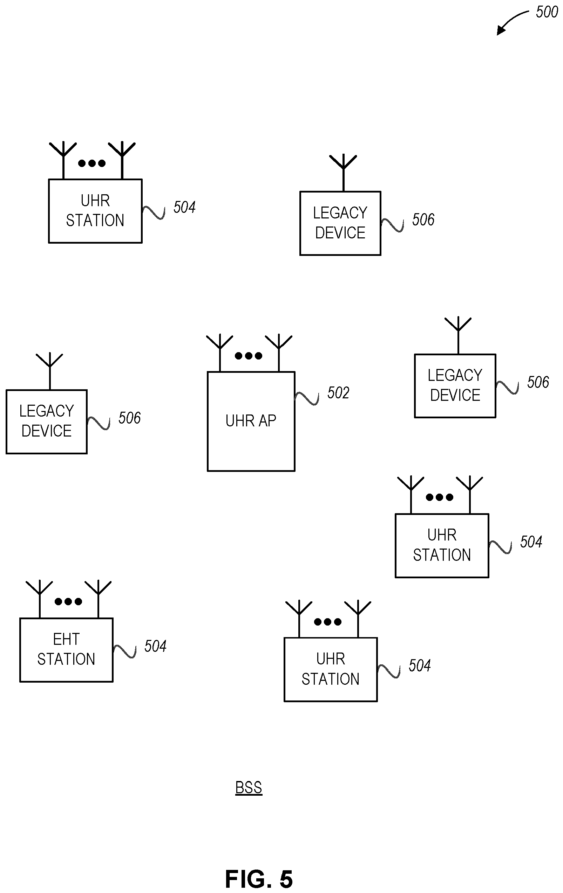

FIG. 5 illustrates a WLAN 500 in accordance with some embodiments. The WLAN 500 may comprise a basis service set (BSS) that may include an EHT access point (AP) 502, which may be termed an AP, a plurality of extremely high throughput (EHT) (e.g., IEEE 802.11be) stations (STAs) 504, and legacy devices 506 (e.g., IEEE 802.11g/n/ac/ax devices). In some aspects, AP 502 is a UHR AP. In some embodiments, the UHR STAs 504 and/or AP 502 are configured to operate in accordance with IEEE 802.11bn. In some embodiments, the UHR STAs 504 and/or AP 502 are configured to operate in accordance with IEEE 802.11bn. In some embodiments, IEEE 802.11bn UHR may be termed Next Generation 802.11. In some embodiments, the AP 502 may be configured to operate a UHR BSS, ER BSS, and/or a BSS. Legacy devices may not be able to operate in the UHR BSS and beacon frames in the UHR BSS may be transmitted using UHR PPDUs. An ER BSS may use ER PPDUs to transmit the beacon frames and legacy devices 506 may not be able to decode the beacon frames and thus are not able to operate in an ER BSS. The BSSs, e.g., BSS, ER BSS, and UHR BSS may use different BSSIDs.

The AP 502 may be an AP using IEEE 802.11 to transmit and receive. The AP 502 may be a base station. The AP 502 may use other communications protocols as well as the IEEE 802.11 protocol. The IEEE 802.11 protocol may be IEEE 802.11bn. The IEEE 802.11 protocol may be IEEE 802.11 next generation. The UHR protocol may be termed a different name in accordance with some embodiments. The IEEE 802.11 protocol may include using orthogonal frequency division multiple-access (OFDMA), time division multiple access (TDMA), and/or code division multiple access (CDMA). The IEEE 802.11 protocol may include a multiple access technique. For example, the IEEE 802.11 protocol may include space-division multiple access (SDMA) and/or multiple-user multiple-input multiple-output (MU-MIMO). There may be more than one AP 502 that is part of an extended service set (ESS). A controller (not illustrated) may store information that is common to more than one UHR APs and may control more than one BSS, e.g., assign primary channels, colors, etc. AP 502 may be connected to the Internet. The AP 502 and/or UHR STA 504 may be configured for one or more of the following: 320 MHz bandwidth, 16 spatial streams, multi-band or multi-stream operation, and 4096 QAM. Additionally, the AP 502 and/or UHR STA 504 may be configured for generating and processing UHR PPDUs that include an extension of the PE field (e.g., a dummy OFDM symbol) (e.g., as disclosed in conjunction with the figures herein) to meet both PHY and MAC processing time requirements.

The legacy devices 506 may operate in accordance with one or more of IEEE 802.11 a/b/g/n/ac/ax/be/ad/af/ah/aj/ay, or another legacy wireless communication standard. The legacy devices 506 may be STAs or IEEE STAs. In some embodiments, when the AP 502 and UHR STAs 504 are configured to operate in accordance with IEEE 802.11bn UHR, the legacy devices 506 may include devices that are configured to operate in accordance with IEEE 802.11ax or 802.11be. The UHR STAs 504 may be wireless transmit and receive devices such as cellular telephones, portable electronic wireless communication devices, smart telephones, handheld wireless devices, wireless glasses, wireless watches, wireless personal devices, tablets, or another device that may be transmitting and receiving using the IEEE 802.11 protocol such as IEEE 802.11bn or another wireless protocol.

The AP 502 may communicate with legacy devices 506 in accordance with legacy IEEE 802.11 communication techniques. In example embodiments, the AP 502 may also be configured to communicate with UHR STAs 504 in accordance with legacy IEEE 802.11 communication techniques.

In some embodiments, a EHT or UHR frame may be configurable to have the same bandwidth as a channel. The EHT or UHR frame may be a Physical Layer Convergence Procedure (PLCP) Protocol Data Unit (PPDU). In some embodiments, there may be different types of PPDUs that may have different fields and different physical layers, and/or different media access control (MAC) layers. For example, a single-user (SU) PPDU, multiple-user (MU) PPDU, extended-range (ER) SU PPDU, and/or trigger-based (TB) PPDU. In some embodiments, UHR PPDUs may be the same or similar to EHT PPDUs.

The bandwidth of a channel may be 20 MHz, 40 MHz, or 80 MHz, 80+80 MHz, 160 MHz, 160+160 MHz, 320 MHz, 320+320 MHz, and 640 MHz bandwidths. In some embodiments, the bandwidth of a channel less than 20 MHz may be 1 MHz, 1.25 MHz, 2.03 MHz, 2.5 MHz, 4.06 MHz, 5 MHz, and 10 MHz, or a combination thereof or another bandwidth that is less or equal to the available bandwidth may also be used. In some embodiments, the bandwidth of the channels may be based on several active data subcarriers. In some embodiments, the bandwidth of the channels is based on 26, 52, 106, 242, 484, 996, or 2x996 active data subcarriers or tones that are spaced by 20 MHz. In some embodiments, the bandwidth of the channels is 256 tones spaced by 20 MHz. In some embodiments, the channels are multiple of 26 tones or a multiple of 20 MHz. In some embodiments, a 20 MHz channel may comprise 242 active data subcarriers or tones, which may determine the size of a Fast Fourier Transform (FFT). An allocation of bandwidth or a number of tones or sub-carriers may be termed a resource unit (RU) allocation in accordance with some embodiments.

In some embodiments, the 26-subcarrier RU and 52-subcarrier RU are used in the 20 MHz, 40 MHz, 80 MHz, 160 MHz, and 80+80 MHz OFDMA EHT or UHR PPDU formats. In some embodiments, the 106-subcarrier RU is used in the 20 MHz, 40 MHz, 80 MHz, 160 MHz, and 80+80 MHz OFDMA and MU-MIMO EHT or UHR PPDU formats. In some embodiments, the 242-subcarrier RU is used in the 40 MHz, 80 MHz, 160 MHz, and 80+80 MHz OFDMA and MU-MIMO EHT or UHR PPDU formats. In some embodiments, the 484-subcarrier RU is used in the 80 MHz, 160 MHz, and 80+80 MHz OFDMA and MU-MIMO EHT or UHR PPDU formats. In some embodiments, the 996-subcarrier RU is used in the 160 MHz and 80+80 MHz OFDMA and MU-MIMO EHT or UHR PPDU formats.

A UHR or EHT frame may be configured for transmitting several spatial streams, which may be in accordance with MU-MIMO and may be in accordance with OFDMA. In other embodiments, the AP 502, the UHR STAs 504, and/or the legacy devices 506 may also implement different technologies such as code division multiple access (CDMA) 2000, CDMA 2000 1X, CDMA 2000 Evolution-Data Optimized (EV-DO), Interim Standard 2000 (IS-2000), Interim Standard 95 (IS-95), Interim Standard 856 (IS-856), Long Term Evolution (LTE), Global System for Mobile communications (GSM), Enhanced Data rates for GSM Evolution (EDGE), GSM EDGE (GERAN), IEEE 802.16 (i.e., Worldwide Interoperability for Microwave Access (WiMAX)), Bluetooth®, low-power Bluetooth®, or other technologies.

In accordance with some IEEE 802.11 embodiments, e.g., IEEE 802.11be/bn EHT/UHR embodiments, an AP 502 may operate as a master station which may be arranged to contend for a wireless medium (e.g., during a contention period) to receive exclusive control of the medium for a transmission opportunity (TXOP). The AP 502 may transmit an UHR/EHT trigger frame, which may include a schedule for simultaneous UL transmissions from UHR STAs 504. The AP 502 may transmit a time duration of the TXOP and sub-channel information. During the TXOP, UHR STAs 504 may communicate with the AP 502 in accordance with a non-contention-based multiple access technique such as OFDMA or MU-MIMO. This is unlike conventional WLAN communications in which devices communicate in accordance with a contention-based communication technique, rather than multiple access techniques. During the UHR or EHT control period, the AP 502 may communicate with UHR STAs 504 using one or more UHR or EHT frames. During the TXOP, the UHR STAs 504 may operate on a sub-channel smaller than the operating range of the AP 502. During the TXOP, legacy stations refrain from communicating. The legacy stations may need to receive the communication from the AP 502 to defer from communicating.

In accordance with some embodiments, during the TXOP the UHR STAs 504 may contend for the wireless medium with the legacy devices 506 being excluded from contending for the wireless medium during the master-sync transmission. In some embodiments, the trigger frame may indicate a UL-MU-MIMO and/or UL OFDMA TXOP. In some embodiments, the trigger frame may include a DL MU-MIMO and/or DL OFDMA with a schedule indicated in a preamble portion of the PPDU carrying the trigger frame.

In some embodiments, the multiple-access technique used during the UHR or EHT TXOP may be a scheduled OFDMA technique, although this is not a requirement. In some embodiments, the multiple access technique may be a time-division multiple access (TDMA) technique or a frequency division multiple access (FDMA) technique. In some embodiments, the multiple access technique may be a space-division multiple access (SDMA) technique. In some embodiments, the multiple access technique may be a Code division multiple access (CDMA).

The AP 502 may also communicate with legacy devices 506 and/or UHR STAs 504 in accordance with legacy IEEE 802.11 communication techniques. In some embodiments, the AP 502 may also be configurable to communicate with UHR STAs 504 outside the UHR TXOP in accordance with legacy IEEE 802.11 or IEEE 802.11be/ax EHT/HE communication techniques, although this is not a requirement.

In some embodiments, the UHR STA 504 may be a "group owner" (GO) for peer-to-peer modes of operation. A wireless device may be a HE or EHT or UHR station or an AP 502. In some embodiments, the UHR STA 504 and/or AP 502 may be configured to operate in accordance with IEEE 802.11mc. In example embodiments, the radio architecture of FIG. 1 is configured to implement the UHR STA 504 and/or the AP 502. In example embodiments, the front-end module circuitry of FIG. 2 is configured to implement the UHR STA 504 and/or the AP 502. In example embodiments, the radio IC circuitry of FIG. 3 is configured to implement the UHR STA 504 and/or the AP 502. In example embodiments, the base-band processing circuitry of FIG. 4 is configured to implement the UHR STA 504 and/or the AP 502.

In example embodiments, the UHR STAs 504, AP 502, an apparatus of the UHR STAs 504, and/or an apparatus of the AP 502 may include one or more of the following: the radio architecture of FIG. 1, the front-end module circuitry of FIG. 2, the radio IC circuitry of FIG. 3, and/or the base-band processing circuitry of FIG. 4.

In example embodiments, the radio architecture of FIG. 1, the front-end module circuitry of FIG. 2, the radio IC circuitry of FIG. 3, and/or the base-band processing circuitry of FIG. 4 may be configured to perform the methods and operations/functions herein described in conjunction with the figures herein or may be implemented as part of devices that perform such methods and operations/functions.

In example embodiments, the UHR STA 504 and/or the AP 502 are configured to perform the methods and operations/functions described herein in conjunction with the figures herein. In example embodiments, an apparatus of the UHR STA 504 and/or an apparatus of the AP 502 are configured to perform the methods and functions described herein in conjunction with the figures herein. The term Wi-Fi may refer to one or more of the IEEE 802.11 communication standards. AP and STA may refer to AP 502 and/or UHR STA 504 (or an EHT STA) as well as legacy devices 506.

In some embodiments, a UHR AP STA may refer to an AP 502 and/or an UHR STAs 504 that is operating as a UHR AP. In some embodiments, when an UHR STA 504 is not operating as a UHR AP, it may be referred to as a UHR non-AP STA or UHR non-AP. In some embodiments, UHR STA 504 may be referred to as either a UHR AP STA or a UHR non-AP. UHR may refer to a next-generation IEEE 802.11 communication protocol, which may be IEEE 802.11bn or may be designated another name.

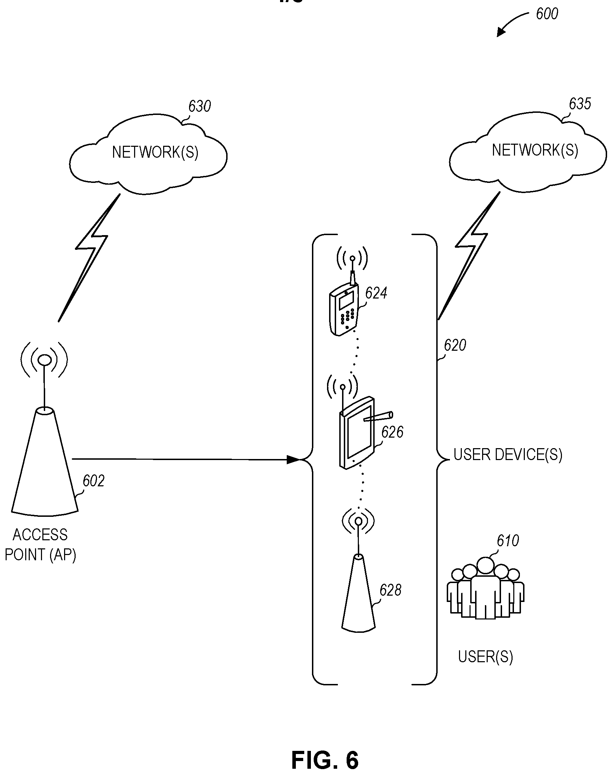

FIG. 6 is a network diagram illustrating an example network environment, in accordance with some embodiments. Wireless network 600 may include one or more user devices 620 and at least one access point (AP) 602, which may communicate in accordance with IEEE 802.11 communication standards. The one or more user devices 620 may be mobile devices that are non-stationary (e.g., not having fixed locations) or may be stationary devices. In some embodiments, the one or more user devices 620 and the at least one AP 602 may include one or more computer systems similar to that of the functional diagram of other figures shown herein.

The one or more user devices 620 and/or at least one AP 602 may be operable by one or more users 610. It should be noted that any addressable unit may be a station (STA). An STA may take on multiple distinct characteristics, each of which shapes its function. For example, a single addressable unit might simultaneously be a portable STA, a quality-of-service (QoS) STA, a dependent STA, and a hidden STA. The one or more user devices 620 and the at least one AP 602 may be STAs. The one or more user devices 620 and/or the at least one AP 602 may operate as a personal basic service set (PBSS) control point/access point (PCP/AP). The one or more user devices 620 (e.g., user device 624, user device 626, or user device 628) and/or the at least one AP 602 may include any suitable processor-driven device including, but not limited to, a mobile device or a non-mobile, e.g., a static device. For example, the one or more user devices 620 and/or the at least one AP 602 may include, user equipment (UE), an STA, an AP, or another device. The one or more user device 620 and/or the at least one AP 602 may also include mesh stations in, for example, a mesh network, in accordance with one or more IEEE 802.11 standards and/or 3GPP standards.

Any of the one or more user devices 620 (e.g., user devices 624-628) and the at least one AP 602 may be configured to communicate with each other via one or more communications networks 630 and/or 635, which can be wireless or wired networks. The one or more user devices 620 may also communicate peer-to-peer or directly with each other with or without the at least one AP 602. Any of the one or more communications networks 630 and/or 635 may include but is not limited to, any one of a combination of different types of suitable communications networks such as broadcasting networks, cable networks, public networks (e.g., the Internet), private networks, wireless networks, cellular networks, or any other suitable private and/or public networks.

Any of the one or more user devices 620 (e.g., user devices 624-628) and the at least one AP 602 may include one or more communications antennas. The one or more communications antennas may be any suitable type of antenna corresponding to the communications protocols used by the one or more user devices 620 (e.g., user devices 624-628), and the at least one AP 602. Some non-limiting examples of suitable communications antennas include Wi-Fi antennas, the IEEE 802.11 family of standards compatible antennas, directional antennas, nondirectional antennas, dipole antennas, folded dipole antennas, patch antennas, multiple-input multiple-output (MIMO) antennas, omnidirectional antennas, quasi-omnidirectional antennas, or the like. The one or more communications antennas may be communicatively coupled to a radio component to transmit and/or receive signals, such as communications signals to and/or from the one or more user devices 620 and/or the at least one AP 602.

Any of the one or more user devices 620 (e.g., user devices 624-628) and the at least one AP 602 may be configured to perform directional transmission and/or directional reception in conjunction with wirelessly communicating in a wireless network. Any of the one or more user devices 620 (e.g., user devices 624-628) and the at least one AP 602 may be configured to perform such directional transmission and/or reception using a set of multiple antenna arrays (e.g., DMG antenna arrays or the like). Each of the multiple antenna arrays may be used for transmission and/or reception in a particular respective direction or range of directions. Any of the one or more user devices 620 (e.g., user devices 624-628), and the at least one AP 602 may be configured to perform any given directional transmission towards one or more defined transmit sectors. Any of the one or more user devices 620 (e.g., user devices 624-628) and the at least one AP 602 may be configured to perform any given directional reception from one or more defined receive sectors.

MIMO beamforming in a wireless network may be accomplished using RF beamforming and/or digital beamforming. In some embodiments, in performing a given MIMO transmission, any of the one or more user devices 620 (e.g., user devices 624-628) and the at least one AP 602 may be configured to use all or a subset of its one or more communications antennas to perform MIMO beamforming.

Any of the one or more user devices 620 (e.g., user devices 624-628) and the at least one AP 602 may include any suitable radio and/or transceiver for transmitting and/or receiving radio frequency (RF) signals in the bandwidth and/or channels corresponding to the communications protocols utilized by any of the one or more user devices 620 and the at least one AP 602 to communicate with each other. The radio components may include hardware and/or software to modulate and/or demodulate communications signals according to pre-established transmission protocols. The radio components may further have hardware and/or software instructions to communicate via one or more Wi-Fi and/or Wi-Fi direct protocols, as standardized by the Institute of Electrical and Electronics Engineers (IEEE) 802.11 standards. In certain example embodiments, the radio component, in cooperation with the communications antennas, may be configured to communicate via 2.4 GHz channels (e.g., 802.11b, 802.11g, 802.11n, 802.11ax, 802.11be), 5 GHz channels (e.g., 802.11n, 802.11ac, 802.11ax, 802.11be), or 60 GHz channels (e.g. 802.11ad, 802.11ay). 700 MHz channels (e.g., 802.11ah). The communications antennas may operate at 28 GHz and 40 GHz. It should be understood that this list of communication channels in accordance with certain 802.11 standards is only a partial list and that other 802.11 standards may be used (e.g., Next Generation Wi-Fi, or other standards). In some embodiments, non-Wi-Fi protocols may be used for communications between devices, such as Bluetooth, dedicated short-range communication (DSRC), Ultra-High Frequency (UHF) (e.g., IEEE 802.11af, IEEE 702.22), white band frequency (e.g., white spaces), or other packetized radio communications. The radio component may include any known receiver and baseband suitable for communicating via the communications protocols. The radio component may further include a low noise amplifier (LNA), additional signal amplifiers, an analog-to-digital (A/D) converter, one or more buffers, and digital baseband. IEEE draft specification IEEE P802.11be/D4.1, September 2023 is incorporated herein by reference in its entirety.

As above, LDPC codes were originally introduced in IEEE 802.11n with three different code word lengths: 648, 1296, 1944. LDPC coding is used for error correction when data is transmitted over PPDUs. PPDUs contain, in addition to the data, a preamble with multiple fields that provide demodulate information, as well as other information for reception. The maximum supported bandwidth at this point was 40MHz. IEEE 802.11ac introduced a 160MHz operation bandwidth and IEEE 802.11be introduced 320 MHz operation bandwidth and 4096 quadrature amplitude modulation (QAM). With the wider bandwidths and higher modulations, one OFDM symbol may contain multiple LDPC codewords. The achievable coding gain increases with an increase in the codeword length. With the introduction of larger operation bandwidths (up to 320MHz) and higher modulations, a longer codeword length may thus be introduced in next generation Wi-Fi, IEEE 802.11bn to improve the performance. Either a 1944x2 or 1944x4 LDPC codeword length may be added to accommodate the increased parameters. In either case however, an update of the LDPC PPDU encoding parameters is desired with the introduction of the new added LDPC codeword length.

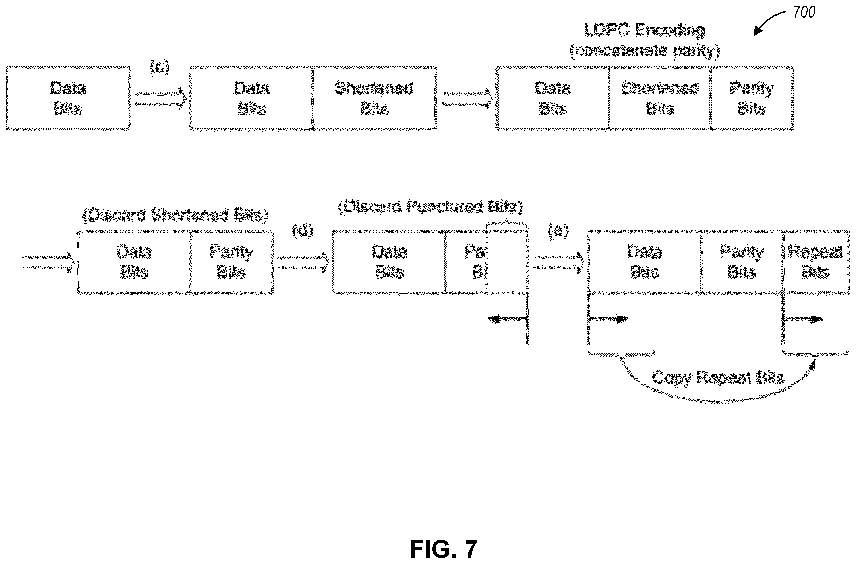

FIG. 7 is a process of LDPC PPDU encoding, in accordance with some embodiments. The process 700 shows encoded padding and puncturing of a single codeword, and includes multiple operations:

To encode an LDPC PPDU, step a) to step g) shall be performed in sequence:

a) Compute the number of available bits, $N_{avbits}$, in the minimum number of OFDM symbols in which the Data field of the (#14) PPDU may fit.

$$N_{pld} = length \times 8 + 16 \qquad (19\text{-}35)$$

$$N_{avbits} = N_{CBPS} \times m_{STBC} \times \left\lceil \frac{N_{pld}}{N_{CBPS} \times R \times m_{STBC}} \right\rceil$$

where:

$N_{CBPS}$ is the number of coded bits per OFDM symbol,
STBC is space-time block coding,
$m_{STBC}$ is 2 if STBC is used and 1 otherwise,
length is the value of the HT Length field in the HT-SIG field defined in Table 19-11 (HT-SIG fields),
$N_{pld}$ is the number of bits in the PSDU and SERVICE field, and
$R$ is the coding rate.

b) Compute the integer number of LDPC codewords to be transmitted, New, and the length of the codewords to be used, $L_{LDPC}$ from Table 19-16 (PPDU encoding parameters).

Table 19-16----PPDU encoding parameters

| Range(bits) of $N_{TCB}$ | Number of LDPC code words ($N_{CW}$) | LDPC code word length in bits ($L_{LDPC}$) |
|---|---|---|
| $N_{avbits} \leq 648$ | 1 | $\begin{cases} 1296, & if\ N_{avbits} \geq N_{pld} + 912 \times (1 - R) \\ 648, & otherwise \end{cases}$ |
| $648 < N_{avbits} \leq 1296$ | 1 | $\begin{cases} 1944, & if\ N_{avbits} \geq N_{pld} + 1464 \times (1 - R) \\ 1296, & otherwise \end{cases}$ |
| $1296 < N_{avbits} \leq 1944$ | 1 | 1944 |
| $1944 < N_{avbits} \leq 2596$ | 2 | $\begin{cases} 1944, & if\ N_{avbits} \geq N_{pld} + 2916 \times (1 - R) \\ 1296, & otherwise \end{cases}$ |
| $2596 < N_{avbits}$ | $\left\lceil \dfrac{N_{pld}}{1944 \cdot R} \right\rceil$ | 1944 |

c) Compute the number of shortening bits, $N_{shrt}$, to be padded to the $N_{pld}$ data bits before encoding, as shown in Equation (19-37).

$$N_{shrt} = \max(0, (N_{CW} \times L_{LDPC} \times R) - N_{pld}) \qquad (19\text{-}37)$$

When $N_{shrt} = 0$, shortening is not performed. (Note that $N_{shrt}$ is inherently restricted to be non-negative due to the codeword length and count selection of Table 19-16 (PPDU encoding parameters)). When $N_{shrt} > 0$, shortening bits shall be equally distributed over all New codewords with the first $N_{shrt}$ mod New codewords shortened 1 bit more than the remaining codewords. Define $N_{spcw} = \lfloor N_{shrt}/N_{CW} \rfloor$. Then, when $N_{shrt} > 0$, the shortening is performed by setting information bits $i_{k-Nspcw-1},...,i_{k-1}$ to 0 in the first $N_{shrt}$ mod $N_{CW}$ codewords and setting informatioon bits $i_{k-Nspcw}, ... , i_{k-1}$ to 0 in the remaining codewords. For all values of $N_{shrt}$, encode each of the *New* codewords using the LDPC encoding technique described in 19.3.11.7.2 (LDPC coding rates and codeword block lengths) to 19.3.11.7.4 (Parity-check matrices). When $N_{shrt} > 0$, the shortened bits shall be discarded after encoding.

d) Compute the number of bits to be punctured, $N_{punc}$, from the codewords after encoding, as shown in Equation (19-38).

$$N_{punc} = \max(0, (N_{CW} \times L_{LDPC}) - N_{avbits} - N_{shrt}) \quad (19\text{-}38)$$

If $((N_{punc} > 0.1 \times N_{CW} \times L_{LDPC} \times (1 - R))$ AND $\left(N_{shrt} < 1.2 \times N_{punc} \times \dfrac{R}{1 - R}\right))$ is true OR if $(N_{punc} > 0.3 \times N_{CW} \times L_{LDPC} \times (1 - R))$ is true, increment $N_{avbits}$ and recompute $N_{punc}$ by the following two equations once:

$$N_{avbits} = N_{avbits} + N_{CBPS} \times m_{STBC} \quad\quad (19\text{-}39)$$

$$N_{punc} = \max(0, (N_{CW} \times L_{LDPC}) - N_{avbits} - N_{shrt}) \quad (19\text{-}40)$$

The punctured bits shall be equally distributed over all *New* codewords with the first $N_{punc}$ mode $N_{CW}$ codewords punctured 1 bit more than the remaining codewords. Define $N_{\mathrm{ppcw}} = \lfloor N_{\mathrm{punc}}/N_{\mathrm{CW}} \rfloor$. When $N_{\mathrm{ppcw}} > 0$, the puncturing is performed by discarding partity bits $P_{n-k-Nppcw-1}, \dots, P_{n-k-1}$ of the first $N_{punc}$ mod $N_{CW}$ codewords and discarding parity bits $(P_{n-k-Nppcw}, \dots, P_{n-k-1})$ of the remaining codewords after encoding. The number of OFDM symbols to be transmitted in the PPDU is computed as shown in Equation (19-41).

$$N_{SYM} = N_{avbits}/N_{CBPS} \quad\quad (19\text{-}41)$$

e) Compute the number of coded bits to be repeated, $N_{rep}$, as shown in Equation (19-42).

$$N_{rep} = \max(0, N_{avbits} - N_{CW} \times L_{LDPC} \times (1 - R) - N_{pld}) \quad (19\text{-}42)$$

The number of coded bits to be repeated shall be equally distributed over all $N_{CW}$ codewords with one more bit repeated for the first $N_{rep}$ mod $N_{CW}$ codewords than for the remaining codewords.

NOTE - When puncturing occurs, the coded bits are not repeated, and vice versa.

The coded bits to be repeated for any codeword shall be copied only from that codeword itself, starting from information bit $i_0$ and continuing sequentially through the information bits and, when necessary, into the parity bits, until the required number of repeated bits is obtained for that codeword. Note that these repeated bits are copied from the codeword after the shortening bits have been removed. If for a codeword the required number of repeated bits are not obtained in this manner (i.e., repeating the codeword once), the procedure is repeated until the required number is achieved. These repeated bits are then concatenated to the codeword after the parity bits in their same order. This process is illustrated in Figure 7. (LDPC PPDU encoding padding and puncturing of a single codeword). In this figure, the outlined arrows indicate the encoding procedure steps, while the solid arrows indicate the direction of puncturing and padding with repeated bits.

f) For each of the *New* codewords, process the data using the number of shortening bits per codeword as computed in step c) for encoding, and puncture or repeat bits per codeword as computed per step d) and step e), as illustrated in Figure 19-13 (LDPC PPDU encoding padding and puncturing of a single codeword).

g) Aggregate all codewords and parse as defined in 19.3.11.7.6 (LDPC parser).

Different options may be used to modify the process 700 shown in FIG. 7. In a first option, a single codeword length is used in the PPDU encoding. If a LDPC codeword length of 3888 (1944x2) and/or 7776 (1944x4) bits are introduced and indicated to be used in the PPDU, the LDPC PPDU encoded process 700 of FIG. 7 may be adjusted. In some aspect, no change occurs to operations a) or c)-g). In operation b), table 19-16 may be updated with changes:

1) When the number of available bits is larger than 1944 and smaller than 2596, two codewords each with a length of 1944 may be used. Alternatively, a single codeword with a length of 3888 may be used as shown in following table. Further definition using a single option may be provided in the IEEE 802.11 specification to avoid extra signaling.

2) When the number of available bits is larger than 2596 and smaller than a TBD value, $N_{TBD1}$, a codeword with a length of 1944 is used. When the number of available bits is larger than $N_{TBD1}$ and smaller than another TBD value, $N_{TBD2}$, a

codeword with a length of 3888 is used. Otherwise, if the number of available bits is larger than $N_{TBD2}$, a codeword with a length of 7776 may be used.

**Table 19-16----PPDU encoding parameters**

| Range(bits) of $N_{TCB}$ | Number of LDPC code words ($N_{CW}$) | LDPC code word length in bits ($L_{LDPC}$) |
|---|---|---|
| $N_{avbits} \leq 648$ | 1 | $\begin{cases} 1296, & if\ N_{avbits} \geq N_{pld} + 912 \\ 648, & otherwise \end{cases}$ |
| $648 < N_{avbits} \leq 1296$ | 1 | $\begin{cases} 1944, & if\ N_{avbits} \geq N_{pld} + 146 \\ 1296, & otherwise \end{cases}$ |
| $1296 < N_{avbits} \leq 1944$ | 1 | 1944 |
| $1944 < N_{avbits} \leq 2596$ | 2<br><br>Or<br><br>$\begin{cases} 1, & if\ N_{avbits} \geq N_{pld} + 2916 \\ 2, & otherwise \end{cases}$ | $\begin{cases} 1944, & if\ N_{avbits} \geq N_{pld} + 291 \\ 1296, & otherwise \end{cases}$<br><br>Or<br><br>$\begin{cases} 3888, & if\ N_{avbits} \geq N_{pld} + 291 \\ 1296, & otherwise \end{cases}$ |
| $2596 < N_{avbits} \leq N_{TBD1}$ | $\left\lceil \dfrac{N_{pld}}{1944 \cdot R} \right\rceil$ | 1944 |
| $N_{TBD1} < N_{avbits} \leq N_{TBD2}$ | $\left\lceil \dfrac{N_{pld}}{3888 \cdot R} \right\rceil$ | 3888 |
| $N_{TED2} < N_{avbits}$ | $\left\lceil \dfrac{N_{pld}}{7776 \cdot R} \right\rceil$ | 7776 |

The value of $N_{TAD1}$ and $N_{TBD2}$ may be determined later.

In a second option, more than one codeword length may be used in the PPDU encoding. In this case, if a LDPC codeword length of 3888 bits is introduced as the added LDPC codeword length and is indicated to be used in the PPDU, a number of operations of the new LDPC PPDU encoded process may be adjusted. As in the first option, operations a), f), and g) may not change, but operations b)-e) may be adjusted. In particular, in operation b), table 19-16 may be updated with changes:

When the number of available bits is larger than 1944 and smaller than 2596, if $N_{avbits} \geq N_{pld} + 2916 \times (1 - R)$, two codewords with a length of 1944 may be used. Alternatively, a single codeword with a length of 3888 may be used as shown in following table. Further definition using a single option may be provided in the IEEE 802.11 specification to avoid extra signaling.

**Table 19-16----PPDU encoding parameters**

| Range(bi ts) of $N_{TCB}$ | Number of LDPC code words ($N_{CW}$) | LDPC code word length in bits ($L_{LDPC}$) |
|---|---|---|
| $N_{avbits} \leq 648$ | 1 | $\begin{cases} 1296, & if\ N_{avbits} \geq N_{pld} + 912 \times (1 - R) \\ 648, & otherwise \end{cases}$ |
| $648 < N_{avbits} \leq 1296$ | 1 | $\begin{cases} 1944, & if\ N_{avbits} \geq N_{pld} + 1464 \times (1 - R) \\ 1296, & otherwise \end{cases}$ |
| $1296 < N_{avbits} \leq 1944$ | 1 | 1944 |

(continued)

| Range(bi ts) of $N_{TCB}$ | Number of LDPC code words ($N_{CW}$) | LDPC code word length in bits ($L_{LDPC}$) |
|---|---|---|
| $1944 < N_{avbits} \leq 2596$ | 2 <br><br> Or <br><br> $\begin{cases} 1, & if\ N_{avbits} \geq N_{pld} + \\ 2, & otherv \end{cases}$ | $\begin{cases} 1944, & if\ N_{avbits} \geq N_{pld} + 2916 \times (1 - \dot{r} \\ 1296, & otherwise \end{cases}$ <br><br> Or <br><br> $\begin{cases} 3888, & if\ N_{avbits} \geq N_{pld} + 2916 \times (1 - \dot{r} \\ 1296, & otherwise \end{cases}$ |
| $2596 < N_{avbits}$ | $\left\lceil \dfrac{N_{pld}}{3888 \cdot R} \right\rceil$ | $\begin{cases} 1944 \times 2 \\ \left( \left\lceil \dfrac{N_{pld}}{3888 \cdot R} \right\rceil - 1 \right) 1944 \times 2\ and\ one\ 1944 \end{cases}$ |

At operation c), when $N_{avbits} > 2596$ and $\mathrm{Mod}\left( \left\lceil \frac{N_{pld}}{1944 \cdot R} \right\rceil, 2 \right) = 0$, the existing rule defined in the IEEE 802.11 specification may be followed to compute the number of shortening bits and distribute the shortening bits over all codewords. Otherwise, when $N_{avbits} > 2596$ and $\mathrm{Mod}\left( \left\lceil \frac{N_{pld}}{1944 \cdot R} \right\rceil, 2 \right) = 1$ where two codeword lengths of 3888 and 1944 are used,

$$N_{shrt} = \max\left( 0, \left( (N_{CW} - 1) \times L_{LDPC,1} + L_{LDPC,2} \right) \times R - N_{pld} \right), L_{LDPC,1} = 3888,$$

$$L_{LDPC,2} = 1944$$

When $N_{shrt} = 0$, shortening is not performed. Otherwise, when $N_{shrt} > 0$, shortening bits are distributed over the $N_{CW}$ codewords, with the shortening bits distributed to the codeword with length 1944, $N_{spcw,1944}$, being half of that distributed to the codeword with length 3888, $N_{spcw.3888}$, which can computed with the following equations:

$$N_{spcw,1944} = \left\lfloor \frac{N_{shrt}}{(2 \cdot N_{CW} - 1)} \right\rfloor;$$

$$N_{spcw,3888} = \left\lfloor \frac{2 \cdot N_{shrt}}{(2 \cdot N_{CW} - 1)} \right\rfloor$$

The remaining $N_{shrt}$ mod $2 \cdot N_{CW}$ - 1 shortening bits, defined as $N_{shrt,\ r} =$ mod $(N_{shrt}, 2 \cdot N_{CW} - 1)$, may be equally distributed over the $(N_{CW} - 1)$ codewords with length 3888. In this case, the first $N_{shrt,\ r}$ mod $N_{CW} - 1$ codewords may be shortened 1 bit more than the remaining codewords.

At operation d), when $N_{avbits} > 2596$ and $\mathrm{Mod}\left( \left\lceil \frac{N_{pld}}{1944 \cdot R} \right\rceil, 2 \right) = 0$, the existing rule defined in the IEEE 802.11 specification may be followed to compute the number of puncturing bits and discard the puncturing bits over all codewords. Otherwise, when $N_{avbits} > 2596$ and $\mathrm{Mod}\left( \left\lceil \frac{N_{pld}}{1944 \cdot R} \right\rceil, 2 \right) = 1$ where two codeword lengths of 3888 and 1944 are used, the number of bits to be punctured, $N_{punc}$, from codewords after encoding, is computed with following equation:

$$N_{punc} = \max\left(0, \left((N_{CW} - 1) \times L_{LDPC,1} + L_{LDPC,2}\right) - N_{avbits} - N_{shrt}\right), L_{LDPC,1} = 3888,$$
$$L_{LDPC,2} = 1944$$

If:

$$\left(\left(N_{punc} > 0.1 \times \left((N_{CW} - 1) \times L_{LDPC,1} + L_{LDPC,2}\right) \times (1 - R)\right) AND \left(N_{shrt}\right.\right.$$

$$\left.\left. < 1.2 \times N_{punc} \times \frac{R}{1 - R}\right)\right)$$

is true OR, if

$$\left(N_{punc} > 0.3 \times \left((N_{CW} - 1) \times L_{LDPC,1} + L_{LDPC,2}\right) \times (1 - R)\right)$$

is true, increment $N_{avbits}$ and recompute $N_{punc}$ by the following two equations once:

$$N_{avbits} = N_{avbits} + N_{CBPS} \times m_{STBC}$$
$$N_{punc} = \max\left(0, \left((N_{CW} - 1) \times L_{LDPC,1} + L_{LDPC,2}\right) - N_{avbits} - N_{shrt}\right), L_{LDPC,1} = 3888,$$
$$L_{LDPC,2} = 1944$$

The punctured bits are distributed over the $N_{CW}$ codewords, with the codeword of length 1944, $N_{spcw,1944}$, being punctured with half the number of bits of that being punctured to the codeword of length 3888, $N_{spcw,3888}$. This may be computed with the following equations:

$$N_{punc,1944} = \left\lfloor \frac{N_{punc}}{(2 \cdot N_{CW} - 1)} \right\rfloor;$$

$$N_{punc,3888} = \left\lfloor \frac{2 \cdot N_{punc}}{(2 \cdot N_{CW} - 1)} \right\rfloor$$

The remaining $N_{punc} \bmod 2 \cdot N_{CW} - 1$ puncturing bits, defined as $N_{punc,\,r} = \bmod(N_{punc}, 2 \cdot N_{CW} - 1)$, may be equally distributed over the $(N_{CW} - 1)$ codewords with length 3888. In this case, the first $N_{shrt,\,r} \bmod N_{CW} - 1$ codewords may be punctured 1 bit more than the remaining codewords.

At operation e), when $N_{avbits} > 2596$ and $\mathrm{Mod}\left(\left\lceil \frac{N_{pld}}{1944 \cdot R} \right\rceil, 2\right) = 0$, the existing rule defined in the IEEE 802.11 specification may be followed to compute the number of repeated bits and distribute the repeated bits over all codewords. Otherwise, when $N_{avbits} > 2596$ and $\mathrm{Mod}\left(\left\lceil \frac{N_{pld}}{1944 \cdot R} \right\rceil, 2\right) = 1$ where two codeword lengths 3888 and 1944 are used, the number of bits to be repeated, $N_{rep}$, over codewords after encoding, is computed with following equation:

$$N_{rep} = \max\left(0, N_{avbits} - \left((N_{CW} - 1) \times L_{LDPC,1} + L_{LDPC,2}\right) \times (1 - R)\right.$$

$$\left. - N_{pld}\right), L_{LDPC,1} = 3888, \qquad L_{LDPC,2} = 1944$$

The number of coded bits to be repeated may be distributed over all codewords with a codeword of length 1944, $N_{rep,1944}$, being repeated with half the number of bits of that being repeated to a codeword of length 3888, $N_{rep,3888}$, which can be computed with the following equations:

$$N_{rep,1944} = \left\lfloor \frac{N_{rep}}{(2 \cdot N_{CW} - 1)} \right\rfloor ;$$

$$N_{rep,3888} = \left\lfloor \frac{2 \cdot N_{rep}}{(2 \cdot N_{CW} - 1)} \right\rfloor$$

For the remaining $N_{rep}$ mod $2 \cdot N_{CW}$ - 1 repeated bits, defined as $N_{rep, r}$ = mod ($N_{rep}$, $2 \cdot N_{CW}$ - 1), if $N_{rep, r} \geq 1$, the codeword with length of 1944 may be repeated with one extra bit and the rest of $N_{rep, r}$ - 1 bits equally distributed over the $N_{CW}$-1 codewords of length 3888 with one more bit repeated for the first $N_{rep, r}$ - 1 mod $N_{CW}$ - 1 codewords with length 3888.

Similar approaches can also be used if codewords of length 7776 is introduced as the added LDPC code word length and is indicated to be used in the PPDU.

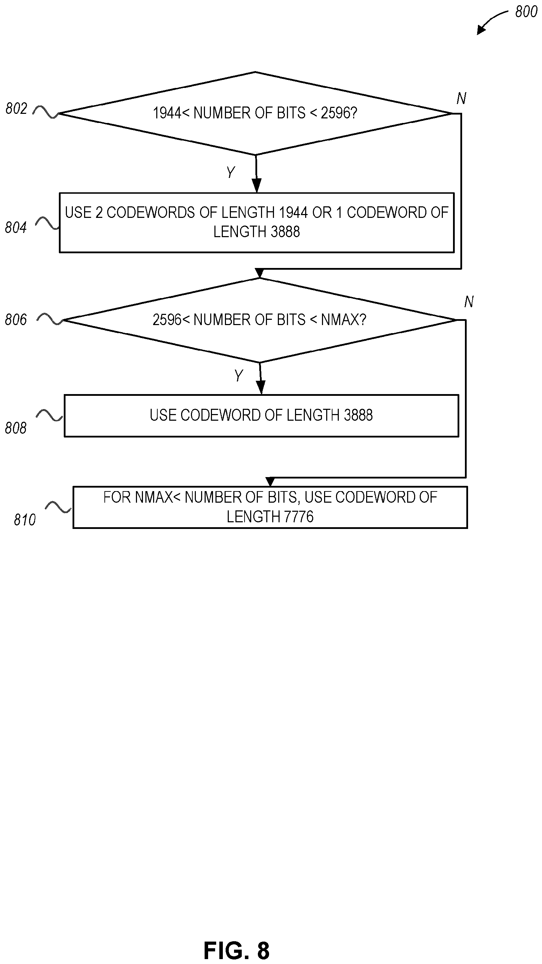

FIG. 8 is a flow diagram of an example method 800 for enhancing LDPC PPDU encoding, in accordance with some embodiments. Method 800 includes operations 802, 804, 806, 808, and 810 which can be performed by processing circuitry in any of the devices (e.g., STA, AP) described herein.

At operation 802, the processing circuitry may determine whether the number of available bits is larger than 1944 and less than 2596 and if $N_{avbits} \geq N_{pld}$ + 2916 $\times$ (1 - $R$).

At operation 804, in response to a determination that the number of available bits is larger than 1944 and less than 2596, the processing circuitry may use two codewords to encode the PPDU. Each codeword may have a length of 1944. Alternatively, the processing circuitry may use a single codeword with a length of 3888 to encode the PPDU.

At operation 806, in response to a determination that the number of available bits is larger than 2596, the processing circuitry may determine whether the number of available bits is also smaller than a maximum value.

At operation 808, in response to a determination that the number of available bits is larger than 2596 and smaller than the maximum value, the processing circuitry may use one or more codewords with a length of 3888 to encode the PPDU.

At operation 810, in response to a determination that the number of available bits is larger than the maximum value, the processing circuitry may use one or more codewords with a length of 7776 to encode the PPDU.

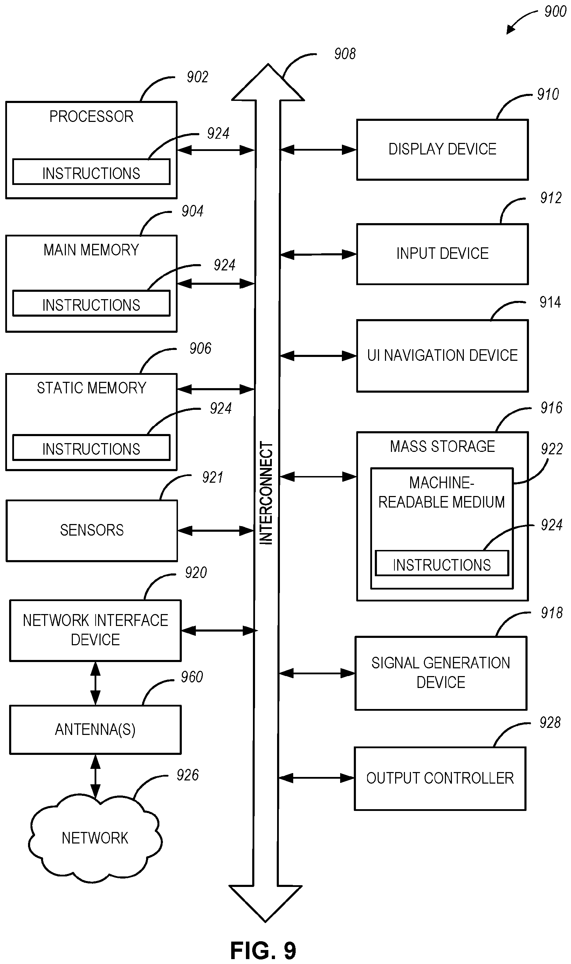

FIG. 9 illustrates a block diagram of an example machine 900 upon which any one or more of the techniques (e.g., methodologies) discussed herein may perform. In alternative embodiments, the machine 900 may operate as a standalone device or may be connected (e.g., networked) to other machines. In a networked deployment, machine 900 may operate in the capacity of a server machine, a client machine, or both in server-client network environments. In an example, machine 900 may act as a peer machine in a peer-to-peer (P2P) (or other distributed) network environment. The machine 900 may be an AP 502, EHT station (STA) 504, personal computer (PC), a tablet PC, a set-top box (STB), a personal digital assistant (PDA), a portable communications device, a mobile telephone, a smartphone, a web appliance, a network router, switch or bridge, or any machine capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations.

Machine (e.g., computer system) 900 may include a hardware processor 902 (e.g., a central processing unit (CPU), a graphics processing unit (GPU), a hardware processor core, or any combination thereof), a main memory 904, and a static memory 906, some or all of which may communicate with each other via an interlink (e.g., bus) 908.

Specific examples of main memory 904 include Random Access Memory (RAM), and semiconductor memory devices, which may include, in some embodiments, storage locations in semiconductors such as registers. Specific examples of static memory 906 include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; RAM; and CD-ROM and DVD-ROM disks.

The machine 900 may further include a display device 910, an input device 912 (e.g., a keyboard), and a user interface (UI) navigation device 914 (e.g., a mouse). In an example, the display device 910, the input device 912, and the UI navigation device 914 may be a touch screen display. The machine 900 may additionally include a storage device (e.g., drive unit) 916, a signal generation device 918 (e.g., a speaker), a network interface device 920, and one or more sensors 921, such as a global positioning system (GPS) sensor, compass, accelerometer, or other sensors. The machine 900 may include an output controller 928, such as a serial bus (e.g., universal serial bus (USB)), parallel, or other wired or wireless (e.g., infrared(IR), near field communication (NFC), etc.) connection to communicate or control one or more peripheral devices (e.g., a printer, card reader, etc.). In some embodiments, the processor 902 and/or instructions 924 may comprise processing circuitry and/or transceiver circuitry.

The storage device 916 may include a machine-readable medium 922 on which is stored one or more sets of data structures or instructions 924 (e.g., software) embodying or utilized by any one or more of the techniques or functions described herein. The instructions 924 may also reside, completely or at least partially, within the main memory 904, within static memory 906, or the hardware processor 902 during execution thereof by the machine 900. In an example, one or any combination of the hardware processor 902, the main memory 904, the static memory 906, or the storage device 916 may constitute machine-readable media.

Specific examples of machine-readable media may include non-volatile memory, such as semiconductor memory devices (e.g., EPROM or EEPROM) and flash memory devices; magnetic disks, such as internal hard disks and removable disks; magneto-optical disks; RAM; and CD-ROM and DVD-ROM disks.

While the machine-readable medium 922 is illustrated as a single medium, the term "machine-readable medium" may include a single medium or multiple media (e.g., a centralized or distributed database, and/or associated caches and servers) configured to store instructions 924.

An apparatus of the machine 900 may be one or more of a hardware processor 902 (e.g., a central processing unit (CPU), a graphics processing unit (GPU), a hardware processor core, or any combination thereof), a main memory 904 and a static memory 906, sensors 921, the network interface device 920, one or more antennas 960, a display device 910, an input device 912, a UI navigation device 914, a storage device 916, instructions 924, a signal generation device 918, and an output controller 928. The apparatus may be configured to perform one or more of the methods and/or operations disclosed herein. The apparatus may be intended as a component of machine 900 to perform one or more of the methods and/or operations disclosed herein, and/or to perform a portion of one or more of the methods and/or operations disclosed herein. In some embodiments, the apparatus may include a pin or other means to receive power. In some embodiments, the apparatus may include power conditioning hardware.

The term "machine-readable medium" may include any medium that is capable of storing, encoding, or carrying instructions for execution by machine 900 and that causes the machine 900 to perform any one or more of the techniques of the present disclosure, or that is capable of storing, encoding or carrying data structures used by or associated with such instructions. Non-limiting machine-readable medium examples may include solid-state memories and optical and magnetic media. Specific examples of machine-readable media may include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; Random Access Memory (RAM); and CD-ROM and DVD-ROM disks. In some examples, machine-readable media may include non-transitory machine-readable media. In some examples, machine-readable media may include machine-readable media that is not a transitory propagating signal.

The instructions 924 may further be transmitted or received over a communications network 926 using a transmission medium via the network interface device 920 utilizing any one of several transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), mobile telephone networks (e.g., cellular networks), Plain Old Telephone (POTS) networks, and wireless data networks (e.g., Institute of Electrical and Electronics Engineers (IEEE) 802.11 family of standards known as Wi-Fi®, IEEE 802.16 family of standards known as WiMax®), IEEE 802.15.4 family of standards, a Long Term Evolution (LTE) family of standards, a Universal Mobile Telecommunications System (UMTS) family of standards, peer-to-peer (P2P) networks, among others.

In an example, the network interface device 920 may include one or more physical jacks (e.g., Ethernet, coaxial, or phone jacks) or one or more antennas to connect to the communications network 926. In an example, the network interface device 920 may include one or more antennas 960 to wirelessly communicate using at least one of single-input multiple-output (SIMO), multiple-input multiple-output (MIMO), or multiple-input single-output (MISO) techniques. In some examples, the network interface device 920 may wirelessly communicate using Multiple User MIMO techniques. The term "transmission medium" shall be taken to include any intangible medium that is capable of storing, encoding, or carrying instructions for execution by the machine 900, and includes digital or analog communications signals or other intangible media to facilitate communication of such software.

Examples, as described herein, may include, or may operate on, logic or several components, modules, or mechanisms. Modules are tangible entities (e.g., hardware) capable of performing specified operations and may be configured or arranged in a certain manner. In an example, circuits may be arranged (e.g., internally or concerning external entities such as other circuits) in a specified manner as a module. In an example, the whole or part of one or more computer systems (e.g., a standalone, client, or server computer system) or one or more hardware processors may be configured by firmware or software (e.g., instructions, an application portion, or an application) as a module that operates to perform specified operations. In an example, the software may reside on a machine-readable medium. In an example, the software, when executed by the underlying hardware of the module, causes the hardware to perform the specified operations.

Accordingly, the term "module" is understood to encompass a tangible entity, be that an entity that is physically constructed, specifically configured (e.g., hardwired), or temporarily (e.g., transitorily) configured (e.g., programmed) to operate in a specified manner or to perform part or all of any operation described herein. Considering examples in which modules are temporarily configured, each of the modules need not be instantiated at any one moment in time. For example, where the modules comprise a general-purpose hardware processor configured using software, the general-purpose hardware processor may be configured as respective different modules at different times. The software may accordingly configure a hardware processor, for example, to constitute a particular module at one instance of time and to constitute a different module at a different instance of time.

Some embodiments may be implemented fully or partially in software and/or firmware. This software and/or firmware may take the form of instructions contained in or on a non-transitory computer-readable storage medium. Those instructions may then be read and executed by one or more processors to enable the performance of the operations described herein. The instructions may be in any suitable form, such as but not limited to source code, compiled code, interpreted code, executable code, static code, dynamic code, and the like. Such a computer-readable medium may include any tangible non-transitory medium for storing information in a form readable by one or more computers, such as but not limited to read-only memory (ROM); random access memory (RAM); magnetic disk storage media; optical storage media; flash memory, etc.

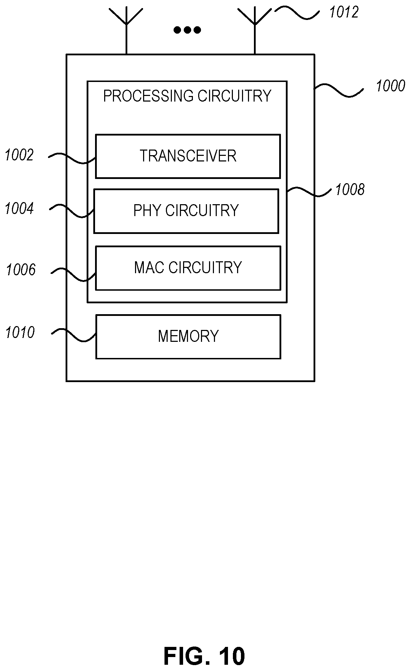

FIG. 10 illustrates a block diagram of an example wireless device 1000 upon which any one or more of the techniques (e.g., methodologies or operations) discussed herein may perform. The wireless device 1000 may be a HE device or a HE wireless device. The wireless device 1000 may be an EHT STA 504, AP 502, and/or a HE STA or HE AP. An EHT STA 504, AP 502, and/or a HE AP or HE STA may include some or all of the components shown in FIGS. 1-15. The wireless device 1000 may be an example of machine 900 as disclosed in conjunction with FIG. 9.

The wireless device 1000 may include processing circuitry 1008. The processing circuitry 1008 may include a transceiver 1002, physical layer circuitry (PHY circuitry) 1004, and MAC layer circuitry (MAC circuitry) 1006, one or more of which may enable transmission and reception of signals to and from other wireless devices (e.g., AP 502, EHT STA 504, and/or legacy devices 506) using one or more antennas 1012. As an example, the PHY circuitry 1004 may perform various encoding and decoding functions that may include the formation of baseband signals for transmission and decoding of received signals. As another example, the transceiver 1002 may perform various transmission and reception functions such as the conversion of signals between a baseband range and a Radio Frequency (RF) range.

Accordingly, the PHY circuitry 1004 and the transceiver 1002 may be separate components or may be part of a combined component, e.g., processing circuitry 1008. In addition, some of the described functionality related to the transmission and reception of signals may be performed by a combination that may include one, any, or all of the PHY circuitry 1004 the transceiver 1002, MAC circuitry 1006, memory 1010, and other components or layers. The MAC circuitry 1006 may control access to the wireless medium. The wireless device 1000 may also include memory 1010 arranged to perform the operations described herein, e.g., some of the operations described herein may be performed by instructions stored in memory 1010.

The one or more antennas 1012 (some embodiments may include only one antenna) may comprise one or more directional or omnidirectional antennas, including, for example, dipole antennas, monopole antennas, patch antennas, loop antennas, microstrip antennas, or other types of antennas suitable for transmission of RF signals. In some multiple-input multiple-output (MIMO) embodiments, the one or more antennas 1012 may be effectively separated to take advantage of spatial diversity and the different channel characteristics that may result.

One or more of the memory 1010, the transceiver 1002, the PHY circuitry 1004, the MAC circuitry 1006, the one or more antennas 1012, and/or the processing circuitry 1008 may be coupled with one another. Moreover, although memory 1010, the transceiver 1002, the PHY circuitry 1004, the MAC circuitry 1006, the one or more antennas 1012 are illustrated as separate components, one or more of memory 1010, the transceiver 1002, the PHY circuitry 1004, the MAC circuitry 1006, the one or more antennas 1012 may be integrated into an electronic package or chip.

In some embodiments, the wireless device 1000 may be a mobile device as described in conjunction with FIG. 9. In some embodiments, the wireless device 1000 may be configured to operate under one or more wireless communication standards as described herein. In some embodiments, the wireless device 1000 may include one or more of the components as described in conjunction with FIG. 9 (e.g., the display device 910, input device 912, etc.) Although the wireless device 1000 is illustrated as having several separate functional elements, one or more of the functional elements may be combined and may be implemented by combinations of software-configured elements, such as processing elements including digital signal processors (DSPs), and/or other hardware elements. For example, some elements may comprise one or more microprocessors, DSPs, field-programmable gate arrays (FPGAs), application-specific integrated circuits (ASICs), radio-frequency integrated circuits (RFICs), and combinations of various hardware and logic circuitry for performing at least the functions described herein. In some embodiments, the functional elements may refer to one or more processes operating on one or more processing elements.

In some embodiments, an apparatus of or used by the wireless device 1000 may include various components of the wireless device 1000 as shown in the figures herein. Accordingly, techniques and operations described herein that refer to the wireless device 1000 may apply to an apparatus for a wireless device 1000 (e.g., AP 502 and/or EHT STA 504), in some embodiments. In some embodiments, the wireless device 1000 is configured to decode and/or encode signals, packets, and/or frames as described herein, e.g., PPDUs.

In some embodiments, the MAC circuitry 1006 may be arranged to contend for a wireless medium during a contention period to receive control of the medium for a HE TXOP and encode or decode a HE PPDU. In some embodiments, the MAC circuitry 1006 may be arranged to contend for the wireless medium based on channel contention settings, a transmitting power level, and a clear channel assessment level (e.g., energy detect level).

The PHY circuitry 1004 may be arranged to transmit signals following one or more communication standards described herein. For example, the PHY circuitry 1004 may be configured to transmit a HE PPDU. The PHY circuitry 1004 may include circuitry for modulation/demodulation, upconversion/downconversion, filtering, amplification, etc. In some embodiments, the processing circuitry 1008 may include one or more processors. The processing circuitry 1008 may be configured to perform functions based on instructions being stored in a RAM or ROM, or based on special-purpose circuitry. The processing circuitry 1008 may include a processor such as a general-purpose processor or a special-purpose processor. The processing circuitry 1008 may implement one or more functions associated with one or more antennas 1012, the transceiver 1002, the PHY circuitry 1004, the MAC circuitry 1006, and/or the memory 1010. In some embodiments, the processing circuitry 1008 may be configured to perform one or more of the functions/operations and/or methods described herein.

In mmWave technology, communication between a station (e.g., the EHT stations 504 of FIG. 5 or wireless device 1000) and an access point (e.g., the AP 502 of FIG. 5 or wireless device 1000) may use associated effective wireless channels that are highly directionally dependent. To accommodate the directionality, beamforming techniques may be utilized to radiate energy in a certain direction with a certain beam width to communicate between two devices. The directed propagation concentrates transmitted energy toward a target device to compensate for significant energy loss in the channel between the two communicating devices. Using directed transmission may extend the range of the millimeter-wave communication versus utilizing the same transmitted energy in omnidirectional propagation.

Examples, as described herein, may include, or may operate on, logic or several components, modules, or mechanisms. Modules are tangible entities (e.g., hardware) capable of performing specified operations and may be configured or arranged in a certain manner. In an example, circuits may be arranged (e.g., internally or concerning external entities such as other circuits) in a specified manner as a module. In an example, the whole or part of one or more computer systems (e.g., a standalone, client, or server computer system) or one or more hardware processors may be configured by firmware or software (e.g., instructions, an application portion, or an application) as a module that operates to perform specified operations. In an example, the software may reside on a machine-readable medium. In an example, the software, when executed by the underlying hardware of the module, causes the hardware to perform the specified operations.

Accordingly, the term "module" is understood to encompass a tangible entity, be that an entity that is physically constructed, specifically configured (e.g., hardwired), or temporarily (e.g., transitorily) configured (e.g., programmed) to operate in a specified manner or to perform part or all of any operation described herein. Considering examples in which modules are temporarily configured, each of the modules need not be instantiated at any one moment in time. For example, where the modules comprise a general-purpose hardware processor configured using the software, the general-purpose hardware processor may be configured as respective different modules at different times. The software may accordingly configure a hardware processor, for example, to constitute a particular module at one instance of time and to constitute a different module at a different instance of time.

Some embodiments may be implemented fully or partially in software and/or firmware. This software and/or firmware may take the form of instructions contained in or on a non-transitory computer-readable storage medium. Those instructions may then be read and executed by one or more processors to enable the performance of the operations described herein. The instructions may be in any suitable form, such as but not limited to source code, compiled code, interpreted code, executable code, static code, dynamic code, and the like. Such a computer-readable medium may include any tangible non-transitory medium for storing information in a form readable by one or more computers, such as but not limited to read-only memory (ROM); random access memory (RAM); magnetic disk storage media; optical storage media; flash memory, etc.

The above-detailed description includes references to the accompanying drawings, which form a part of the detailed description. The drawings show, by way of illustration, specific embodiments that may be practiced. These embodiments are also referred to herein as "examples." Such examples may include elements in addition to those shown or described. However, also contemplated are examples that include the elements shown or described. Moreover, also contemplated are examples using any combination or permutation of those elements shown or described (or one or more aspects thereof), either concerning a particular example (or one or more aspects thereof) or concerning other examples (or one or more aspects thereof) shown or described herein.

Publications, patents, and patent documents referred to in this document are incorporated by reference herein in their entirety, as though individually incorporated by reference. In the event of inconsistent usage between this document and those documents so incorporated by reference, the usage in the incorporated reference(s) is supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc. are used merely as labels and are not intended to suggest a numerical order for their objects.

The embodiments as described above may be implemented in various hardware configurations that may include a processor for executing instructions that perform the techniques described. Such instructions may be contained in a machine-readable medium such as a suitable storage medium or a memory or other processor-executable medium.

The embodiments as described herein may be implemented in several environments such as part of a wireless local area network (WLAN), 3rd Generation Partnership Project (3GPP) Universal Terrestrial Radio Access Network (UTRAN), or Long-Term-Evolution (LTE) or a Long-Term-Evolution (LTE) communication system, although the scope of the disclosure is not limited in this respect.

Antennas referred to herein may comprise one or more directional or omnidirectional antennas, including, for example, dipole antennas, monopole antennas, patch antennas, loop antennas, microstrip antennas, or other types of antennas suitable for transmission of RF signals. In some embodiments, instead of two or more antennas, a single antenna with multiple apertures may be used. In these embodiments, each aperture may be considered a separate antenna. In some multiple-input multiple-output (MIMO) embodiments, antennas may be effectively separated to take advantage of spatial diversity and the different channel characteristics that may result between each antenna and the antennas of a transmitting station. In some MIMO embodiments, antennas may be separated by up to 1/10 of a wavelength or more.

Described implementations of the subject matter can include one or more features, alone or in combination as illustrated below by way of examples.

Examples

Example 1 is an apparatus of a station (STA), the apparatus comprising: memory; and processing circuitry coupled to the memory, the processing circuitry to configure the STA to: determine a number of available bits (Navbits) in a minimum number of orthogonal frequency division multiplexing (OFDM) symbols in which data bits in a data field of a Physical Layer Convergence Protocol (PLCP) packet protocol data unit (PPDU) fits; determine a Low-Density Parity Check (LDPC) codeword and a number of LDPC codewords (NCW) to be transmitted, the LDPC codeword selected from a set of LDPC codewords that include LDPC codewords of at least one of length 3888 or 7776 bits; encode, based on the number of LDPC codewords, the data bits to create encoded data bits; form a PPDU using the encoded data bits; and transmit a frame that contains the PPDU to another STA.

In Example 2, the subject matter of Example 1 includes, wherein the processing circuitry configures the STA to: determine a number of shortening bits to be padded to the data bits before encoding; determine a number of bits to be punctured from the LDPC codewords after encoding; determine a number of coded bits to be repeated; for each of the LDPC codewords, process data using the number of shortening bits per LDPC codeword for encoding and at least one of puncture or repeat bits per LDPC codeword as determined; and aggregate the LDPC codewords to form aggregated LDPC codewords and parse the aggregated LDPC codewords to form parsed LDPC codewords, which are to be transmitted to the other STA.

In Example 3, the subject matter of Example 2 includes, wherein the number of shortening bits, the number of bits to be punctured, and the number of coded bits to be repeated are dependent on which of a single codeword length or multiple codeword lengths are to be used during PPDU encoding.

In Example 4, the subject matter of Examples 2-3 includes, wherein the processing circuitry configures the STA to, in response to a determination that multiple codeword lengths are to be used during PPDU encoding, distribute each of the number of shortening bits, the number of bits to be punctured, and the number of coded bits to be repeated among the LDPC codewords proportional to a relative length of the LDPC codewords.

In Example 5, the subject matter of Example 4 includes, wherein the processing circuitry configures the STA to, in response to a determination that remaining bits are to be distributed for at least one of the number of shortening bits, the number of bits to be punctured, and the number of coded bits to be repeated, distribute the remaining bits among the LDPC codewords having a longest length.

In Example 6, the subject matter of Examples 1-5 includes, wherein the processing circuitry configures the STA to: determine that a single codeword length is to be used during PPDU encoding; determine that the number of available bits is larger than 1944 and smaller than 2596 and that the number of available bits is equal to or greater than a combination of $N_{pld}$ plus $2916 \times (1 - R)$, where $N_{pld}$ is a number of bits in the data field and a service field of the PPDU, and R is a coding rate; and in response to a determination that the number of available bits is larger than 1944 and smaller than 2596 and that the number of available bits is equal to or greater than the combination, use two LDPC codewords with length 1944 or a single LDPC codeword with length of 3888 for the encoding.

In Example 7, the subject matter of Examples 1-6 includes, wherein the processing circuitry configures the STA to: determine that a single codeword length is to be used during PPDU encoding; and in response to a determination that the number of available bits is larger than 2596 and: smaller than a first predetermined value, use LDPC codewords with length 1944, larger than the first predetermined value and smaller than a second predetermined value, use LDPC codewords with length 3888, and larger than the second predetermined value, use LDPC codewords with length 7776

In Example 8, the subject matter of Examples 1-7 includes, wherein the processing circuitry configures the STA to: determine that multiple codeword lengths are to be used during PPDU encoding; determine that the number of available bits is larger than 1944 and smaller than 2596 and that the number of available bits is equal to or greater than a combination of $N_{pld}$ plus $2916 \times (1 - R)$, where $N_{pld}$ is a number of bits in the data field and a service field of the PPDU, and R is a coding rate; and in response to a determination that the number of available bits is larger than 1944 and smaller than 2596 and that the number of available bits is equal to or greater than the combination, use LDPC codewords with length 1944 or a single LDPC codeword with length of 3888 for the encoding.

In Example 9, the subject matter of Example 8 includes, wherein the processing circuitry configures the STA to: determine a number of shortening bits (Nshrt) to be padded to the data bits prior to encoding; and distribute the shortening bits among the LDPC codewords in response to a determination that the number of available bits is larger than 2596 and

$$\text{Mod}\left(\left\lceil \frac{N_{pld}}{1944 \cdot R} \right\rceil, 2\right) = 1$$, where LDPC codeword lengths of 3888 ($L_{LDPC,1}$) and 1944 ($L_{LDPC,2}$) are used, and $N_{shrt}$ = max (0, (($N_{CW}$ - 1) $\times L_{LDPC,1} + L_{LDPC,2}) \times R - N_{pld}$) where $N_{shrt}$ = 0, shortening is not performed, and where $N_{shrt}$ > 0, shortening bits are distributed over the LDPC codewords, with the shortening bits distributed to the LDPC codewords with length 1944 being half compared to LDPC codewords with length 3888 and remaining shortening bits ($N_{shrt,\ r}$) equally distributed over ($N_{CW}$ - 1) LDPC codewords with length 3888 with the first ($N_{shrt,\ r}$ mod $N_{CW}$ - 1) codewords shortened 1 bit more than remaining LDPC codewords.

In Example 10, the subject matter of Example 9 includes, wherein the processing circuitry configures the STA to: determine a number of punctured bits to be punctured (Npunc) from the LDPC codewords after encoding; in response to a determination that the number of available bits is larger than 2596 and $$\text{Mod}\left(\left\lceil \frac{N_{pld}}{1944 \cdot R} \right\rceil, 2\right) = 1$$, where LDPC codeword lengths of 3888 and 1944 are used, and $N_{punc}$ = max (0, (($N_{CW}$ - 1) $\times L_{LDPC,1} + L_{LDPC,2}) - N_{avbits} - N_{shrt}$) ,where for when at least one of: (((($N_{punc}$ > 0.1 $\times$ (($N_{CW}$ - 1) $\times L_{LDPC,1} + L_{LDPC,2}) \times (1 - R))$ AND $$\left(N_{shrt} < 1.2 \times N_{punc} \times \frac{R}{1-R}\right)$$) or ($N_{punc}$ > 0.3 $\times$ (($N_{CW}$ - 1) $\times L_{LDPC,1} + L_{LDPC,2}) \times (1 - R))$, is true, increment $N_{avbits}$ and recompute $N_{punc}$ once based on: $N_{avbits} = N_{avbits} + N_{CBPS} \times m_{STBC}$ $N_{punc}$ = max (0, (($N_{CW}$ - 1) $\times L_{LDPC,1} + L_{LDPC,2}) - N_{avbits} - N_{shrt}$) , where $N_{CBPS}$ is a number of coded bits per OFDM symbol, and $m_{STBC}$ is 2 for use of space-time block coding (STBC) and 1 otherwise.

In Example 11, the subject matter of Example 10 includes, wherein the processing circuitry configures the STA to: distribute the punctured bits over the LDPC codewords, with LDPC codewords of length 1944 being punctured with half the number of punctured bits compared to LDPC codewords of length 3888, and distribute remaining puncturing bits ($N_{punc,\ r}$), defined as mod ($N_{punc}, 2 \cdot N_{CW}$ - 1), equally over the ($N_{CW}$ - 1) LDPC codewords with length 3888, and puncture the first $N_{shrt,\ r}$ mod $N_{CW}$ - 1 codewords one bit more than the remaining LDPC codewords.

In Example 12, the subject matter of Example 11 includes, wherein the processing circuitry configures the STA to: distribute the punctured bits over the LDPC codewords, with LDPC codewords of length 1944 being punctured with half the number of punctured bits compared to LDPC codewords of length 3888, and distribute remaining puncturing bits ($N_{punc,\ r}$), defined as mod ($N_{punc}, 2 \cdot N_{CW}$ -1), equally over the ($N_{CW}$ - 1) LDPC codewords with length 3888, and puncture the first $N_{shrt,\ r}$ mod $N_{CW}$ - 1 codewords one bit more than the remaining LDPC codewords.

In Example 13, the subject matter of Example 12 includes, the processing circuitry configures the STA to, for remaining repeated bits ($N_{rep,\ r}$), defined as mod ($N_{rep}, 2 \cdot N_{CW}$ - 1), repeat LDPC codewords of length 1944 with one extra bit and equally distribute a remainder of $N_{rep,\ r}$ - 1 bits over the $N_{CW}$-1 LDPC codewords of length 3888 with one more bit repeated for the first $N_{rep,\ r}$ - 1 mod $N_{CW}$ - 1 LDPC codewords of length 3888.

Example 14 is an apparatus of an access point (AP), the apparatus comprising: memory; and processing circuitry coupled to the memory, the processing circuitry to configure the AP to: determine a number of available bits (Navbits) in a minimum number of orthogonal frequency division multiplexing (OFDM) symbols in which data bits in a data field of a Physical Layer Convergence Protocol (PLCP) packet protocol data unit (PPDU) fits; determine a Low-Density Parity Check (LDPC) codeword and a number of LDPC codewords (NCW) to be transmitted, the LDPC codeword selected from a set of LDPC codewords that include LDPC codewords of at least one of length 3888 or 7776 bits; encode, based on the number of LDPC codewords, the data bits to form encoded data bits; form a PPDU using the encoded data bits; and transmit a frame that contains the PPDU to a station (STA).

In Example 15, the subject matter of Example 14 includes, wherein the processing circuitry configures the AP to: determine a number of shortening bits to be padded to the data bits before encoding; determine a number of bits to be punctured from the LDPC codewords after encoding; determine a number of coded bits to be repeated; for each of the LDPC codewords, process data using the number of shortening bits per LDPC codeword for encoding and at least one of puncture or repeat bits per LDPC codeword as determined, the number of shortening bits, the number of bits to be punctured, and the number of coded bits to be repeated are dependent on which of a single codeword length or multiple codeword lengths are to be used during PPDU encoding; and aggregate the LDPC codewords to form aggregated LDPC codewords and parse the aggregated LDPC codewords to form parsed LDPC codewords, which are to be transmitted to the STA.

In Example 16, the subject matter of Example 15 includes, wherein the processing circuitry configures the STA to, in response to a determination that multiple codeword lengths are to be used during PPDU encoding, distribute each of the number of shortening bits, the number of bits to be punctured, and the number of coded bits to be repeated among the LDPC codewords proportional to a relative length of the LDPC codewords.

In Example 17, the subject matter of Example 16 includes, wherein the processing circuitry configures the STA to, in response to a determination that remaining bits are to be distributed for at least one of the number of shortening bits, the number of bits to be punctured, and the number of coded bits to be repeated, distribute the remaining bits among the LDPC codewords having a longest length.

Example 18 is a non-transitory computer-readable storage medium that stores instructions for execution by one or more processors of an apparatus of a station (STA), the instructions to cause the one or more processors to: determine a number of available bits (Navbits) in a minimum number of orthogonal frequency division multiplexing (OFDM) symbols in which data bits in a data field of a Physical Layer Convergence Protocol (PLCP) packet protocol data unit (PPDU) fits; determine a Low-Density Parity Check (LDPC) codeword and a number of LDPC codewords (NCW) to be transmitted, the LDPC codeword selected from a set of LDPC codewords that include LDPC codewords of at least one of length 3888 or 7776 bits; encode, based on the number of LDPC codewords, the data bits to form encoded data bits; form a PPDU using the encoded data bits; and transmit a frame that contains the PPDU to an access point (AP).

In Example 19, the subject matter of Example 18 includes, wherein the instructions further cause the one or more processors to: determine a number of shortening bits to be padded to the data bits before encoding; determine a number of bits to be punctured from the LDPC codewords after encoding; determine a number of coded bits to be repeated; for each of the LDPC codewords, process data using the number of shortening bits per LDPC codeword for encoding and at least one of puncture or repeat bits per LDPC codeword as determined; and aggregate the LDPC codewords to form aggregated LDPC codewords and parse the aggregated LDPC codewords to form parsed LDPC codewords, which are to be transmitted to the AP.

In Example 20, the subject matter of Example 19 includes, wherein the instructions further cause the one or more processors to: in response to a determination that multiple codeword lengths are to be used during PPDU encoding, distribute each of the number of shortening bits, the number of bits to be punctured, and the number of coded bits to be repeated among the LDPC codewords proportional to a relative length of the LDPC codewords, and in response to a determination that remaining bits are to be distributed for at least one of the number of shortening bits, the number of bits to be punctured, and the number of coded bits to be repeated, distribute the remaining bits among the LDPC codewords having a longest length.

Example 21 is at least one machine-readable medium including instructions that, when executed by processing circuitry, cause the processing circuitry to perform operations to implement of any of Examples 1-20.

Example 22 is an apparatus comprising means to implement of any of Examples 1-20.

Example 23 is a system to implement of any of Examples 1-20.

Example 24 is a method to implement of any of Examples 1-20.

In some of the examples, the frames may be transmitted using up to a 320 MHz or 480 MHz bandwidth and 4096 quadrature amplitude modulation (QAM).

Although an embodiment has been described with reference to specific example embodiments, it will be evident that various modifications and changes may be made to these embodiments without departing from the broader scope of the present disclosure. Accordingly, the specification and drawings are to be regarded in an illustrative rather than a restrictive sense. The accompanying drawings that form a part hereof show, by way of illustration, and not of limitation, specific embodiments in which the subject matter may be practiced. The embodiments illustrated are described in sufficient detail to enable those skilled in the art to practice the teachings disclosed herein. Other embodiments may be utilized and derived therefrom, such that structural and logical substitutions and changes may be made without departing from the scope of this disclosure. This Detailed Description, therefore, is not to be taken in a limiting sense, and the scope of various embodiments is defined only by the appended claims, along with the full range of equivalents to which such claims are entitled.

The subject matter may be referred to herein, individually and/or collectively, by the term "embodiment" merely for convenience and without intending to voluntarily limit the scope of this application to any single inventive concept if more than one is in fact disclosed. Thus, although specific embodiments have been illustrated and described herein, it should be appreciated that any arrangement calculated to achieve the same purpose may be substituted for the specific embodiments shown. This disclosure is intended to cover any and all adaptations or variations of various embodiments. Combinations of the above embodiments, and other embodiments not specifically described herein, will be apparent to those of skill in the art upon reviewing the above description.

In this document, the terms "a" or "an" are used, as is common in patent documents, to indicate one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, UE, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects. As indicated herein, although the term "a" is used herein, one or more of the associated elements may be used in different embodiments. For example, the term "a processor" configured to carry out specific operations includes both a single processor configured to carry out all of the operations as well as multiple processors individually configured to carry out some or all of the operations (which may overlap) such that the combination of processors carry out all of the operations. Further, the term "includes" may be considered to be interpreted as "includes at least" the elements that follow.

The Abstract of the Disclosure is submitted with the understanding that it will not be used to interpret or limit the scope or meaning of the claims. In addition, in the foregoing Detailed Description, it may be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the Detailed Description, with each claim standing on its own as a separate embodiment.

**Claims**

1. An apparatus of a station "STA" (504, 900), the apparatus comprising:

   memory (904, 908); and
   processing circuitry (902) coupled to the memory, the processing circuitry (902) configured to:

   determine a number of available bits "$N_{avbits}$" in a minimum number of orthogonal frequency division multiplexing "OFDM" symbols in which data bits in a data field of a Physical Layer Convergence Protocol "PLCP" packet protocol data unit "PPDU" fits;
   determine a Low-Density Parity Check "LDPC" codeword and a number of LDPC codewords "New" to be transmitted, the LDPC codeword selected from a set of LDPC codewords that include LDPC codewords of at least one of length 3888 or 7776 bits;
   encode, based on the number of LDPC codewords, the data bits to create encoded data bits;
   form a PPDU using the encoded data bits; and
   encode a frame that contains the PPDU for transmission to another STA (504, 900).

2. The apparatus of claim 1, wherein the processing circuitry (902) is configured to:

   determine a number of shortening bits to be padded to the data bits before encoding;
   determine a number of bits to be punctured from the LDPC codewords after encoding;
   determine a number of coded bits to be repeated;
   for each of the LDPC codewords, process data using the number of shortening bits per LDPC codeword for encoding and at least one of puncture or repeat bits per LDPC codeword as determined; and
   aggregate the LDPC codewords to form aggregated LDPC codewords and parse the aggregated LDPC codewords to form parsed LDPC codewords, which are to be transmitted to the other STA.

3. The apparatus of claim 2, wherein the number of shortening bits, the number of bits to be punctured, and the number of coded bits to be repeated are dependent on which of a single codeword length or multiple codeword lengths are to be used during PPDU encoding.

4. The apparatus of claim 2, wherein the processing circuitry (902) is configured to, in response to a determination that multiple codeword lengths are to be used during PPDU encoding, distribute each of the number of shortening bits, the number of bits to be punctured, and the number of coded bits to be repeated among the LDPC codewords proportional to a relative length of the LDPC codewords.

5. The apparatus of claim 4, wherein the processing circuitry (902) is configured to, in response to a determination that remaining bits are to be distributed for at least one of the number of shortening bits, the number of bits to be punctured, and the number of coded bits to be repeated, distribute the remaining bits among the LDPC codewords having a longest length.

6. The apparatus of claim 1, wherein the processing circuitry (902) is configured to:

   determine that a single codeword length is to be used during PPDU encoding;
   determine that the number of available bits is larger than 1944 and smaller than 2596 and that the number of available bits is equal to or greater than a combination of $N_{pld}$ plus 2916 x (1 - R), where $N_{pld}$ is a number of bits in the data field and a service field of the PPDU, and R is a coding rate; and
   in response to a determination that the number of available bits is larger than 1944 and smaller than 2596 and that the number of available bits is equal to or greater than the combination, use two LDPC codewords with length 1944 or a single LDPC codeword with length of 3888 for the encoding.

7. The apparatus of claim 1, wherein the processing circuitry (902) is configured to:

   determine that a single codeword length is to be used during PPDU encoding; and
   in response to a determination that the number of available bits is larger than 2596 and:

      smaller than a first predetermined value, use LDPC codewords with length 1944,
      larger than the first predetermined value and smaller than a second predetermined value, use LDPC codewords with length 3888, and
      larger than the second predetermined value, use LDPC codewords with length 7776.

8. The apparatus of claim 1, wherein the processing circuitry (902) is configured to:

   determine that multiple codeword lengths are to be used during PPDU encoding;
   determine that the number of available bits is larger than 1944 and smaller than 2596 and that the number of available bits is equal to or greater than a combination of $N_{pld}$ plus 2916 x (1 - R), where $N_{pld}$ is a number of bits in the data field and a service field of the PPDU, and R is a coding rate; and
   in response to a determination that the number of available bits is larger than 1944 and smaller than 2596 and that the number of available bits is equal to or greater than the combination, use LDPC codewords with length 1944 or a single LDPC codeword with length of 3888 for the encoding.

9. The apparatus of claim 8, wherein the processing circuitry (902) is configured to:

   determine a number of shortening bits ($N_{shrt}$) to be padded to the data bits prior to encoding; and
   distribute the shortening bits among the LDPC codewords in response to a determination that the number of available bits is larger than 2596 and $$\text{Mod}\left(\left\lceil \frac{N_{pld}}{1944 \cdot R} \right\rceil, 2\right) = 1$$ , where LDPC codeword lengths of 3888 ($L_{LDPC,1}$) and 1944 ($L_{LDPC,2}$) are used, in which:

$$N_{shrt} = \max\left(0, \left((N_{CW} - 1) \times L_{LDPC,1} + L_{LDPC,2}\right) \times R - N_{pld}\right)$$

   where $N_{shrt}$ = 0, shortening is not performed, and
   where $N_{shrt}$ > 0, shortening bits are distributed over the LDPC codewords, with the shortening bits distributed to the LDPC codewords with length 1944 being half compared to LDPC codewords with length 3888 and remaining shortening bits ($N_{shrt,\,r}$) equally distributed over ($N_{CW}$- 1) LDPC codewords with length 3888 with the first ($N_{shrt,\,r}$ mod $N_{CW}$ - 1) codewords shortened 1 bit more than remaining LDPC codewords.

10. The apparatus of claim 9, wherein the processing circuitry (902) is configured to:

determine a number of punctured bits to be punctured ($N_{punc}$) from the LDPC codewords after encoding; and in response to a determination that the number of available bits is larger than 2596 and

$$\text{Mod}\left(\left\lceil\frac{N_{pld}}{1944 \cdot R}\right\rceil, 2\right) = 1$$

, where LDPC codeword lengths of 3888 and 1944 are used, in which:

$$N_{punc} = \max\left(0, \left((N_{CW} - 1) \times L_{LDPC,1} + L_{LDPC,2}\right) - N_{avbits} - N_{shrt}\right),$$

where for when at least one of:

$$\left(\left(N_{punc} > 0.1 \times \left((N_{CW} - 1) \times L_{LDPC,1} + L_{LDPC,2}\right) \times (1 - R)\right) AND \left(N_{shrt}\right.\right.$$

$$\left.\left.< 1.2 \times N_{punc} \times \frac{R}{1 - R}\right)\right)$$

or

$$\left(N_{punc} > 0.3 \times \left((N_{CW} - 1) \times L_{LDPC,1} + L_{LDPC,2}\right) \times (1 - R)\right),$$

is true, increment $N_{avbits}$ and recompute $N_{punc}$ once based on:

$$N_{avbits} = N_{avbits} + N_{CBPS} \times m_{STBC}$$

$$N_{punc} = \max\left(0, \left((N_{CW} - 1) \times L_{LDPC,1} + L_{LDPC,2}\right) - N_{avbits} - N_{shrt}\right),$$

where $N_{CBPS}$ is a number of coded bits per OFDM symbol, and $m_{STBC}$ is 2 for use of space-time block coding (STBC) and 1 otherwise.

11. The apparatus of claim 10, wherein the processing circuitry (902) is configured to:

distribute the punctured bits over the LDPC codewords, with LDPC codewords of length 1944 being punctured with half the number of punctured bits compared to LDPC codewords of length 3888, and distribute remaining puncturing bits ($N_{punc,\,r}$), defined as mod ($N_{punc}$, 2 · $N_{CW}$- 1), equally over the ($N_{CW}$- 1) LDPC codewords with length 3888, and puncture the first $N_{shrt,\,r}$ mod $N_{CW}$- 1 codewords one bit more than the remaining LDPC codewords.

12. The apparatus of claim 11, wherein the processing circuitry (902) is configured to:

in response to a determination that the number of available bits is larger than 2596 and $\text{Mod}\left(\left\lceil\frac{N_{pld}}{1944 \cdot R}\right\rceil, 2\right) = 1$, where LDPC codeword lengths of 3888 and 1944 are used, determine a number of coded bits to be repeated ($N_{rep}$) over LDPC codewords after encoding as:

$$N_{rep} = \max\left(0, N_{avbits} - \left((N_{CW} - 1) \times L_{LDPC,1} + L_{LDPC,2}\right) \times (1 - R) - N_{pld}\right)$$

where the number of coded bits to be repeated are distributed over all LDPC codewords, with LDPC codewords of length 1944 being repeated with half the number of bits compared to LDPC codewords of length 3888.

13. The apparatus of claim 12, wherein the processing circuitry (902) is configured to, for remaining repeated bits ($N_{rep, r}$), defined as mod ($N_{rep}, 2 \cdot N_{CW} - 1$), repeat LDPC codewords of length 1944 with one extra bit and equally distribute a remainder of $N_{rep, r}$ - 1 bits over the $N_{CW}$-1 LDPC codewords of length 3888 with one more bit repeated for the first $N_{rep, r}$ - 1 mod $N_{CW}$ - 1 LDPC codewords of length 3888.

14. A computer-readable storage medium that stores instructions for execution by one or more processors (902) of an apparatus of a station "STA" (504, 900), the instructions to cause the one or more processors (902) to:

   determine a number of available bits ($N_{avbits}$) in a minimum number of orthogonal frequency division multiplexing "OFDM" symbols in which data bits in a data field of a Physical Layer Convergence Protocol "PLCP" packet protocol data unit (PPDU) fits;
   determine a Low-Density Parity Check "LDPC" codeword and a number of LDPC codewords ($N_{CW}$) to be transmitted, the LDPC codeword selected from a set of LDPC codewords that include LDPC codewords of at least one of length 3888 or 7776 bits;
   encode, based on the number of LDPC codewords, the data bits to form encoded data bits;
   form a PPDU using the encoded data bits; and
   transmit a frame that contains the PPDU to an access point "AP" (502, 900).

15. The medium of claim 14, wherein the instructions further cause the one or more processors (902) to:

   determine a number of shortening bits to be padded to the data bits before encoding;
   determine a number of bits to be punctured from the LDPC codewords after encoding;
   determine a number of coded bits to be repeated;
   for each of the LDPC codewords, process data using the number of shortening bits per LDPC codeword for encoding and at least one of puncture or repeat bits per LDPC codeword as determined;
   aggregate the LDPC codewords to form aggregated LDPC codewords and parse the aggregated LDPC codewords to form parsed LDPC codewords, which are to be transmitted to the AP:

      in response to a determination that multiple codeword lengths are to be used during PPDU encoding, distribute each of the number of shortening bits, the number of bits to be punctured, and the number of coded bits to be repeated among the LDPC codewords proportional to a relative length of the LDPC codewords, and in response to a determination that remaining bits are to be distributed for at least one of the number of shortening bits, the number of bits to be punctured, and the number of coded bits to be repeated, distribute the remaining bits among the LDPC codewords having a longest length.

**FIG. 1**

**FIG. 2**

**FIG. 3**

**FIG. 4**

500

UHR
STATION  504

LEGACY
DEVICE  506

LEGACY
DEVICE  506

UHR AP  502

LEGACY
DEVICE  506

UHR
STATION  504

EHT
STATION  504

UHR
STATION  504

BSS

**FIG. 5**

**FIG. 6**

LDPC Encoding
(concatenate parity)

700

(c)

Data Bits → Data Bits | Shortened Bits → Data Bits | Shortened Bits | Parity Bits

(Discard Shortened Bits)

(Discard Punctured Bits)

(d)

(e)

Data Bits | Parity Bits → Data Bits | Pa... B... → Data Bits | Parity Bits | Repeat Bits

Copy Repeat Bits

**FIG. 7**

800

802 — ◇ 1944< NUMBER OF BITS < 2596? ◇ N

Y

804 — USE 2 CODEWORDS OF LENGTH 1944 OR 1 CODEWORD OF LENGTH 3888

806 — ◇ 2596< NUMBER OF BITS < NMAX? ◇ N

Y

808 — USE CODEWORD OF LENGTH 3888

810 — FOR NMAX< NUMBER OF BITS, USE CODEWORD OF LENGTH 7776

**FIG. 8**

900

902

PROCESSOR

INSTRUCTIONS

924

908

INTERCONNECT

910

DISPLAY DEVICE

904

MAIN MEMORY

INSTRUCTIONS

924

912

INPUT DEVICE

906

STATIC MEMORY

INSTRUCTIONS

924

914

UI NAVIGATION DEVICE

921

SENSORS

916

MASS STORAGE

922

MACHINE-READABLE MEDIUM

924

INSTRUCTIONS

920

NETWORK INTERFACE DEVICE

918

SIGNAL GENERATION DEVICE

960

ANTENNA(S)

928

OUTPUT CONTROLLER

926

NETWORK

**FIG. 9**

**FIG. 10**

**Europäisches Patentamt**
**European Patent Office**
**Office européen des brevets**

# EUROPEAN SEARCH REPORT

**Application Number**

EP 24 18 8844

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2022/368453 A1 (HU SHENGQUAN [US] ET AL) 17 November 2022 (2022-11-17) | 1-5,14, 15 | INV. H03M13/11 |
| A | * the whole document * | 6-13 | H03M13/00 H04L1/00 |
| Y | 802 11 WORKING GROUP OF THE LAN/MAN STANDARDS COMMITTEE OF THE IEEE COMPUTER SOCIETY: "Draft Standard for Information Technology- Telecommunications and Information Exchange between Systems Local and Metropolitan Area Networks- Specific Requirements Part 11: Wireless LAN Medium Access Control (MAC) and Physical Layer (PHY) Specifications", IEEE DRAFT; DRAFT P802.11REVME_D4.0 REDLINE COMPARED TO D3.1, IEEE-SA, PISCATAWAY, NJ USA , no. D4.0 10 August 2023 (2023-08-10), pages 1-5884, XP068202830, Retrieved from the Internet: URL:https://grouper.ieee.org/groups/802/11 /private/Draft_Standards/11me/Draft%20P802 .11REVme_D4.0%20Redline%20Compared%20to%20 D3.1.pdf [retrieved on 2023-08-10] * section 19.3.11.7, p.3283-3288 * | 2-5,15 | H04L5/00 |
| Y | US 2021/211143 A1 (RICHARDSON THOMAS JOSEPH [US] ET AL) 8 July 2021 (2021-07-08) * the whole document * | 1,14 | TECHNICAL FIELDS SEARCHED (IPC) H03M H04L |
| Y | US 2016/323060 A1 (HASSANIN MOHAMED K [US] ET AL) 3 November 2016 (2016-11-03) * the whole document * | 1,14 | |

The present search report has been drawn up for all claims

| Place of search | Date of completion of the search | Examiner |
|---|---|---|
| Munich | 28 December 2024 | Wu, Zifeng |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 8844

This annex lists the patent family members relating to the patent documents cited in the above-mentioned European search report.
The members are as contained in the European Patent Office EDP file on
The European Patent Office is in no way liable for these particulars which are merely given for the purpose of information.

28-12-2024

| Patent document cited in search report | Publication date | Patent family member(s) | | Publication date |
|---|---|---|---|---|
| US 2022368453 A1 | 17-11-2022 | CN | 113014268 A | 22-06-2021 |
| | | DE | 102020133739 A1 | 24-06-2021 |
| | | US | 2022368453 A1 | 17-11-2022 |
| US 2021211143 A1 | 08-07-2021 | CN | 114902569 A | 12-08-2022 |
| | | EP | 4085533 A1 | 09-11-2022 |
| | | KR | 20220093002 A | 04-07-2022 |
| | | TW | 202133564 A | 01-09-2021 |
| | | US | 2021211143 A1 | 08-07-2021 |
| | | WO | 2021138182 A1 | 08-07-2021 |
| US 2016323060 A1 | 03-11-2016 | CN | 106101050 A | 09-11-2016 |
| | | US | 2016323060 A1 | 03-11-2016 |

EPO FORM P0459

For more details about this annex : see Official Journal of the European Patent Office, No. 12/82